# EUROPEAN PATENT SPECIFICATION

(11) **EP 4 064 376 B1**
(45) Date of publication and mention of the grant of the patent: **01.05.2024**
(21) Application number: 22160519.9
(22) Date of filing: 07.03.2022
(51) Int. Cl.: H10K 30/88, H10K 85/10

(54) **PHOTOELECTRIC CONVERSION ELEMENT**
FOTOELEKTRISCHES UMWANDLUNGSELEMENT
ÉLÉMENT DE CONVERSION PHOTOÉLECTRIQUE

(30) Priority: 18.03.2021 JP 2021044329
(43) Date of publication of application: 28.09.2022
(73) Proprietor: Ricoh Company, Ltd., Tokyo 143-8555 (JP)
(72) Inventor: HIRANO, Tomoya, Tokyo 143-8555 (JP); ARAI, Ryota, Tokyo 143-8555 (JP); ITO, Takaya, Tokyo 143-8555 (JP)
(74) Representative: J A Kemp LLP

(56) References cited:
- US-A1- 2009 114 905
- US-A1- 2017 149 005

## Description

### BACKGROUND

### Technical Field

The present disclosure relates to a photoelectric conversion element, an electronic device, and a power supply module.

### Description of the Related Art

In recent years, achievement of Internet of Things (IoT) society, in which everything is connected to the Internet to enable comprehensive control, has been expected. To achieve such an IoT society, a large number of sensors are required to be coupled to various things to obtain data, but power supplies that drive such a large number of sensors are needed. Wiring to the various sensors and use of storage cells are impractical, and power supply achieved by an environmental power generation element is expected because of an increase in a social need for reducing environmental load.

Among others, photoelectric conversion elements have been attracting attention as elements that can generate electricity anywhere if light is available. In particular, flexible photoelectric conversion elements have been expected to be highly efficient and also be applicable to, for example, wearable devices by virtue of their followability to variously curved surfaces.

For example, Applied Physics letters, 108, 253301 (2016) and Japanese Journal of Applied Physics, 54, 071602 (2015) report the results of studies on applicability of photoelectric conversion elements to wearable devices.

In general, as highly efficient flexible environmental power generation elements, organic thin-film solar cells are considered to be promising. JP-2014-220333-A proposes a photoelectric conversion element including a transparent base film as a base.
US 2017/149005 A1 and US 2009/114905 A1 disclose background art to the invention.

A photoelectric conversion element in a typical organic thin-film solar cell has a structure including a first electrode, an electron transporting layer, a photoelectric conversion layer, a hole transporting layer, and a second electrode that are stacked in this order on or above a base serving as a support substrate. The photoelectric conversion element having such a structure degrades in functions due to entry of, for example, water into the photoelectric conversion element. Thus, the photoelectric conversion element is additionally provided with a sealing member for preventing entry of external substances into the photoelectric conversion element. Such a sealing member is known and is, for example, a member having a film that is to cover the photoelectric conversion element having the above configuration from the second electrode side to be attached to a member on the base side.

Even in the photoelectric conversion element provided with a sealing member for preventing entry of external substances, the photoelectric conversion efficiency thereof decreases when it is placed in a high-temperature, high-humidity environment for a long period of time.

### SUMMARY

According to the present invention there is provided a photoelectric conversion element, an electronic device and a power supply module as defined in the appended claims.

The present disclosure can provide a photoelectric conversion element that is prevented from decreasing in photoelectric conversion efficiency even if placed in a high-temperature, high-humidity environment for a long period of time.

### BRIEF DESCRIPTION OF THE SEVERAL VIEWS OF THE DRAWINGS

A more complete appreciation of the disclosure and many of the attendant advantages and features thereof can be readily obtained and understood from the following detailed description with reference to the accompanying drawings, wherein:
FIG. 1 is a schematic diagram illustrating one example of a photoelectric conversion element as viewed from the above;
FIG. 2 is a schematic cross-sectional diagram illustrating one example of a photoelectric conversion element;
FIG. 3 is a schematic cross-sectional diagram illustrating one example of a structure of a photoelectric conversion element in the vicinity of an adhesion region;
FIG. 4A is a schematic diagram illustrating one example of a method for producing a photoelectric conversion module;
FIG. 4B is a schematic diagram illustrating one example of a method for producing a photoelectric conversion module;
FIG. 4C is a schematic diagram illustrating one example of a method for producing a photoelectric conversion module;
FIG. 4D is a schematic diagram illustrating one example of a method for producing a photoelectric conversion module;
FIG. 4E is a schematic diagram illustrating one example of a method for producing a photoelectric conversion module;
FIG. 4F is a schematic diagram illustrating one example of a method for producing a photoelectric conversion module;
FIG. 4G is a schematic diagram illustrating one example of a method for producing a photoelectric conversion module;
FIG. 4H is a schematic diagram illustrating one example of a method for producing a photoelectric conversion module;
FIG. 4I is a schematic diagram illustrating one example of a method for producing a photoelectric conversion module;
FIG. 4J is a schematic diagram illustrating one example of a method for producing a photoelectric conversion module;
FIG. 4K is a schematic diagram illustrating one example of a method for producing a photoelectric conversion module;
FIG. 5 is a schematic diagram illustrating one example of a basic configuration of an electronic device;
FIG. 6 is a schematic diagram illustrating one example of a basic configuration of an electronic device;
FIG. 7 is a schematic diagram illustrating one example of a basic configuration of an electronic device;
FIG. 8 is a schematic diagram illustrating one example of a basic configuration of a power supply module;
FIG. 9 is a schematic diagram illustrating one example of a basic configuration of a power supply module;
FIG. 10 is a schematic diagram illustrating one example of a basic configuration of a mouse for a personal computer;
FIG. 11 is a schematic outside diagram illustrating one example of the mouse for a personal computer illustrated in FIG. 10;
FIG. 12 is a schematic diagram illustrating one example of a basic configuration of a keyboard for a personal computer;
FIG. 13 is a schematic outside diagram illustrating one example of the keyboard for a personal computer illustrated in FIG. 12;
FIG. 14 is a schematic outside diagram illustrating another example of the keyboard for a personal computer illustrated in FIG. 12;
FIG. 15 is a schematic diagram illustrating one example of a basic configuration of a sensor;
FIG. 16 is a schematic diagram illustrating one example of when data obtained through sensing with a sensor is transmitted to a personal computer, a smartphone, etc. via wireless communication; and
FIG. 17 is a schematic diagram illustrating one example of a basic configuration of a turntable.

The accompanying drawings are intended to depict embodiments of the present invention and should not be interpreted to limit the scope thereof. The accompanying drawings are not to be considered as drawn to scale unless explicitly noted.

### DETAILED DESCRIPTION

The terminology used herein is for the purpose of describing particular embodiments only and is not intended to be limiting of the present invention. As used herein, the singular forms "a", "an" and "the" are intended to include the plural forms as well, unless the context clearly indicates otherwise.

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Embodiments of the present disclosure will be described below.

### «Photoelectric conversion element>>

The "photoelectric conversion element" refers to an element that converts light energy to electric energy or an element that converts electric energy to light energy. Specifically, the photoelectric conversion element is, for example, an element forming a solar cell, a photodiode, etc.

The photoelectric conversion element includes a first electrode, a photoelectric conversion layer over the first electrode, and a second electrode over the photoelectric conversion layer. In other words, the photoelectric conversion element includes a first electrode, a photoelectric conversion layer, and a second electrode sequentially. The term "sequentially" means that these electrodes and the layer are arranged in the order mentioned above as a whole, and any other layers may be inserted between each of the electrodes and the layer. The photoelectric conversion element including the other layers that are inserted therebetween is, for example, a photoelectric conversion element sequentially including the first electrode, an electron transporting layer, the photoelectric conversion layer, a hole transporting layer, and the second electrode. In this case, moreover, other additional layers may be inserted between each of the electrodes and the layer or between the layers. Also, the term "sequentially" means that these electrodes and layers may be stacked in order from the side of the first electrode or these electrodes and layers may be stacked in order from the side of the second electrode. Specifically, as observed from the side of the light incident surface, the photoelectric conversion element may be such that the first electrode, the photoelectric conversion layer, and the second electrode are stacked in the order mentioned, or may be such that the second electrode, the photoelectric conversion layer, and the first electrode are stacked in the order mentioned. When the photoelectric conversion element includes an electron transporting layer and a hole transporting layer, as observed from the side of the light incident surface, the photoelectric conversion element may be such that the first electrode, the electron transporting layer, the photoelectric conversion layer, the hole transporting layer, and the second electrode are stacked in the order mentioned, or may be such that the second electrode, the hole transporting layer, the photoelectric conversion layer, the electron transporting layer, and the first electrode in the order mentioned. In the present disclosure, description will be mainly made for the photoelectric conversion element where the first electrode, the electron transporting layer, the photoelectric conversion layer, the hole transporting layer, and the second electrode are stacked in the order mentioned, as observed from the side of the light incident surface. However, the present photoelectric conversion element is not limited to this configuration. Persons skilled in the art could easily understand other configurations from the below-given description, such as a photoelectric conversion element where the second electrode, the hole transporting layer, the photoelectric conversion layer, the electron transporting layer, and the first electrode are stacked in the order mentioned, as observed from the side of the light incident surface.

The photoelectric conversion element includes a sealing member. The sealing member encloses: one electrode selected from the first electrode and the second electrode (hereinafter the electrode selected as the one electrode may also be referred to as "one electrode"); and the photoelectric conversion layer. When the photoelectric conversion element includes an electron transporting layer and a hole transporting layer, the sealing member encloses the electron transporting layer and the hole transporting layer as well. The sealing member adheres to an adhesion region in the other electrode selected from the first electrode and the second electrode (hereinafter the electrode selected as the other electrode may also be referred to as "the other electrode"). The term "enclose" means that the one electrode, the photoelectric conversion layer, etc. are provided in a space formed by at least the sealing member and the other electrode. The above space may be formed by other structures (e.g., a terminal) in addition to the sealing member and the other electrode. The term "adhesion region" means a region in the other electrode which directly or indirectly contacts the sealing member to adhere thereto, the region being located at part of the opposite face to the one electrode. The positional relationship between the "one electrode" and the "other electrode" is not particularly limited. In the present disclosure, a mainly described embodiment is that the one electrode is an electrode provided at a farther position from the light incident surface and the other electrode is an electrode provided at a nearer position to the light incident surface. However, the present photoelectric conversion element is not limited to such an embodiment. Persons skilled in the art could easily understand other embodiments from the below-given description, such as an embodiment where the one electrode is an electrode provided at a nearer position to the light incident surface and the other electrode is an electrode provided at a farther position from the light incident surface.

If necessary, the photoelectric conversion element includes, for example, a base, a surface protection layer, a sealing member, and a UV cut layer.

When the photoelectric conversion element includes a base, a preferable configuration of the photoelectric conversion element as observed from the side of the light incident surface is: a configuration where the base, the first electrode, the electron transporting layer, the photoelectric conversion layer, the hole transporting layer, and the second electrode are stacked in the order mentioned; or a configuration where the base, the second electrode, the hole transporting layer, the photoelectric conversion layer, the electron transporting layer, and the first electrode are stacked in the order mentioned. The base is preferably provided adjacent to the other electrode at a side of a face of the other electrode where the adhesion region is absent.

### <Base>

The "base" is a member configured to support, for example, the electrodes and the layers that form the photoelectric conversion element. From the viewpoint of increasing photoelectric conversion efficiency, the base is preferably high in light transmittivity and more preferably transparent. From the viewpoint of broadening applications of the photoelectric conversion element, the base is preferably high in flexibility.

Examples of the material of the base having transparency and flexibility include, but are not limited to: resin films of, for example, polyesters such as polyethylene terephthalate, polycarbonates, polyimides, polymethyl methacrylates, polysulfones, and polyether ether ketone; and glass thin films having an average thickness of 200 µm or less. Of these materials, from the viewpoints of easiness to produce and of cost, resin films of polyesters and polyimides, and glass thin films are preferable.

Examples of the material of the base having transparency but having no flexibility include, but are not limited to, inorganic transparent crystals such as glass. These materials are preferable because they have no flexibility but have high flatness.

The base preferably has gas barrier property. The gas barrier property is the function of preventing transmission of water vapor and oxygen. In the present disclosure, the "base having gas barrier property" is not limited to a base that intrinsically has gas barrier property, and also includes a stack including a base and a gas barrier layer, which is at a position adjacent to the base and has gas barrier property. The base having gas barrier property can provide a photoelectric conversion element that is better prevented from decreasing in photoelectric conversion efficiency even if it is placed in a high-temperature, high-humidity environment for a long period of time. The gas barrier layer will be described below.

The function required for the base having gas barrier property is typically represented by, for example, a water vapor transmission rate or an oxygen transmission rate. Preferably, the water vapor transmission rate per day according to the method stipulated by JIS (Japanese Industrial Standards) K7129 B is, for example, 1 × 10⁻² g/m² or lower, and the lower it is, the more preferable. Preferably, the oxygen transmission rate per day according to the method stipulated by JIS K7126-2 is, for example, 1 cm³/m²·atm or lower, and the lower it is, the more preferable.

As the resin film having gas barrier property, a known resin film may be appropriately used. Examples thereof include, but are not limited to, aluminum-coated resin films and silicon oxide-coated resin films.

### <First electrode>

The "first electrode" is an electrode configured to collect electrons generated through photoelectric conversion. When the first electrode is provided on the light incident surface side, the first electrode is preferably high in light transmission and more preferably transparent from the viewpoint of increasing photoelectric conversion efficiency. When the first electrode is provided on the opposite side to the light incident surface, light transmission and transparency may be low.

As the first electrode having transparency, a transparent electrode may be used that is an electrode transparent to visible light. The transparent electrode is, for example, a structure including a transparent conductive film, a metal thin film, and a transparent conductive film that are sequentially stacked. The two transparent conductive films, which sandwich the metal thin film, may be formed of the same material or of different materials.

Examples of the material of the transparent conductive film include, but are not limited to, tin-doped indium oxide (ITO), zinc-doped indium oxide (IZO), zinc oxide (ZnO), fluorine-doped tin oxide (FTO), aluminum-doped zinc oxide (AZO), gallium-doped zinc oxide (GZO), tin oxide (SnO₂), silver nanowires, and nanocarbons (e.g., carbon nanotubes and graphene). Of these materials, preferable are tin-doped indium oxide (ITO), zinc-doped indium oxide (IZO), and aluminum-doped zinc oxide (AZO).

Examples of the material of the metal thin film include, but are not limited to, metals such as aluminum, copper, silver, gold, platinum, and nickel.

The first electrode having transparency is preferably integrated in use with the above base from the viewpoint of maintaining rigidity. Examples of such integrated products include, but are not limited to, FTO-coated glass, ITO-coated glass, aluminum-coated glass, FTO-coated transparent plastic films, ITO-coated transparent plastic films, and ITO/silver/ITO stack-coated plastic films.

Examples of the material of the first electrode having no transparency include, but are not limited to, metals such as platinum, gold, silver, copper, and aluminum, and graphite.

The average thickness of the first electrode is preferably 5 nm or greater but 10 µm or less and more preferably 50 nm or greater but 1 µm or less.

The sheet resistance of the first electrode is preferably 50 Ω/sq. or lower, more preferably 30 Ω/sq. or lower, and further preferably 20 Ω/sq. or lower.

When the first electrode has transparency, the light transmittance of the first electrode is preferably 60% or higher, more preferably 70% or higher, further preferably 80% or higher, and particularly preferably 90% or higher. The upper limit of the light transmittance is not particularly limited and may be appropriately selected depending on the intended purpose.

The first electrode can be formed through wet film formation, dry film formation such as vapor deposition or sputtering, or printing.

### <Electron transporting layer>

The "electron transporting layer" is a layer configured to transport electrons generated in the photoelectric conversion layer and prevent entry of holes generated in the photoelectric conversion layer. In the configuration, one electron transporting layer may be present or two or more electron transporting layers may be present. As one example, the following is described about the configuration including two electron transporting layers. Specifically, this is a configuration including a first electron transporting layer and a second electron transporting layer (which may also be referred to as an "intermediate layer") that is provided between the first electron transporting layer and the photoelectric conversion layer. When the intended configuration includes one electron transporting layer, the one electron transporting layer is preferably the same layer as the first electron transporting layer.

### -First electron transporting layer-

The first electron transporting layer is preferably a layer containing particles of a metal oxide.

Examples of the metal oxide include, but are not limited to: oxides of, for example, titanium, zinc, lithium, and tin; and ITO, FTO, ATO, AZO, and GZO. Of these, zinc oxide is preferable, and in order to increase conductivity, a doped zinc oxide is more preferable. Examples of the doped zinc oxide include, but are not limited to, aluminum-doped zinc oxide, gallium-doped zinc oxide, and lithium-doped zinc oxide. The metal oxide for use may be a metal oxide formed of, for example, an alkoxide of a metal serving as a raw material.

The average particle diameter of the particles of the metal oxide is preferably 1 nm or more but 50 nm or less and more preferably 5 nm or more but 20 nm or less.

The average particle diameter of the particles of the metal oxide is calculated by measuring 100 or more randomly selected metal oxide particles for particle diameter in the following manner, for example, and by determining the average of the measurements obtained. First, a dispersion liquid containing the particles of the metal oxide is transferred to a nebulizer made of glass using a micropipette. Next, the dispersion liquid is sprayed from the nebulizer to a grid for a TEM and with a collodion film. Using PVD, the grid is allowed to undergo carbon vapor deposition. Under an electron microscope, an image of the particles of the metal oxide is obtained. The obtained image is subjected to image processing to measure the particle diameters of the particles of the metal oxide. Alternatively, the cross-section of the photoelectric conversion element may be observed under a scanning transmission electron microscope (TEM) to perform particle recognition through image processing, to thereby measure the particle diameters of the particles of the metal oxide. Also, the particle size distribution may be measured by, for example, a laser diffraction and scattering method. Known methods can be employed for a method of exposing the cross-section of the photoelectric conversion element, observation under a TEM, and measurement of the particle size distribution.

The average thickness of the first electron transporting layer is preferably 1 nm or greater but 300 nm or less and more preferably 10 nm or greater but 150 nm or less.

An exemplary method for forming the first electron transporting layer is a method of applying a dispersion liquid containing the particles of the metal oxide and a dispersion medium, followed by drying. Examples of the dispersion medium include, but are not limited to, alcohols such as methanol, ethanol, isopropanol, 1-propanol, 2-methoxyethanol, and 2-ethoxyethanol, and mixtures thereof.

### -Second electron transporting layer (intermediate layer)-

The second electron transporting layer is preferably a layer containing an amine compound. The amine compound is not particularly limited as long as it is a material that can increase photoelectric conversion efficiency of the photoelectric conversion element as a result of formation of the second electron transporting layer. For example, an amine compound represented by General Formula (4) below is preferably used.

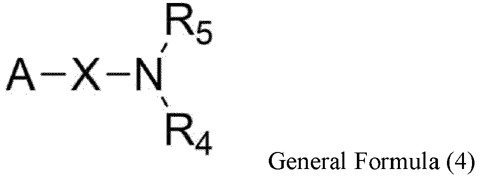

In the above General Formula (4), R₄ and R₅ each independently represent an alkyl group which may have a substituent and contains carbon atoms of 1 or more but 4 or less, or represent a ring structure where R₄ and R₅ are bonded to each other. Preferably, R₄ and R₅ represent an alkyl group which may have a substituent and contains carbon atoms of 1 or more but 4 or less. More preferably, R₄ and R₅ each independently represent an alkyl group which has no substituent and contains carbon atoms of 1 or more but 4 or less. Examples of the substituent include, but are not limited to, a methyl group, an ethyl group, and a hydroxyl group. The number of carbon atoms in the above ring structure is preferably 3 or more but 6 or less. When R₄ and R₅ each independently represent an alkyl group which may have a substituent and contains carbon atoms of 1 or more but 4 or less, the alkyl group represented by R₄ and the alkyl group represented by R₅ may be identical to or different from each other.

In the above General Formula (4), X represents a divalent aromatic group having carbon atoms of 6 or more but 14 or less or an alkyl group having carbon atoms of 1 or more but 4 or less. X is preferably a divalent aromatic group having carbon atoms of 6 or more but 14 or less.

In the above General Formula (4), A represents a substituent of Structural Formula (1), (2), or (3). A is preferably a substituent of Structural Formula (1).

-COOH Structural Formula (1)

-P(=O)(OH)₂ Structural Formula (2)

-Si(OH)₃ Structural Formula (3)

Examples of the amine compound other than those represented by the above General Formula (4) include, but are not limited to, 3-aminopropyltriethoxysilane, 3-aminopropyltriethoxysilane, 3-aminopropyldiethoxymethylsilane, 3-(2-aminoethylamino)propyltriethoxysilane, 3-(2-aminoethylamino)propyldimethoxymethylsilane, 3-(2-aminoethylamino)propyltriethoxysilane, trimethoxy[3-(phenylamino)propyl]silane, trimethoxy[3-(methylamino)propyl]silane, bis[3-(trimethoxysilyl)propyl]amine, bis[3-(triethoxysilyl)propyl]amine, and N,N'-bis[3-(trimethoxysilyl)propyl]ethane-1,2-diamine.

An exemplary method for forming the second electron transporting layer is a method of applying a solution containing the amine compound through, for example, spin coating or dipping, followed by drying.

### <Photoelectric conversion layer>

The "photoelectric conversion layer" is a layer configured to absorb light to generate electrons and holes. The photoelectric conversion layer contains two or more kinds of organic materials. Specifically, the photoelectric conversion layer contains an electron-donating organic material (which may also be referred to as a p-type organic semiconductor material) and an electron-accepting organic material (which may also be referred to as a n-type organic semiconductor material). The electron-donating organic material and the electron-accepting organic material may each use two or more kinds of organic materials. It is preferable that the photoelectric conversion layer contain three or more kinds of organic materials. Also, in the photoelectric conversion layer, the electron-donating organic material and the electron-accepting organic material are preferably mixed to form a bulk heterostructure.

### -Electron-donating organic material-

The electron-donating organic material is preferably a π-electron conjugated compound having a highest occupied molecular orbital (HOMO) level of 4.8 eV or higher but 5.7 eV or lower and more preferably a π-electron conjugated compound having a HOMO level of 5.1 eV or higher but 5.5 eV or lower or a π-electron conjugated compound having a HOMO level of 5.2 eV or higher but 5.6 eV or lower.

The highest occupied molecular orbital (HOMO) level can be measured through, for example, photoelectron spectroscopy or cyclic voltammetry. Specifically, it can be measured using a device such as AC-3 available from RIKEN KEIKI CO., LTD.

Examples of the electron-donating organic material include, but are not limited to: conjugated polymers coupled with various aromatic derivatives (e.g., thiophene, fluorene, carbazole, thienothiophene, benzodithiophene, dithienosilole, quinoxaline, and benzothiadiazole); and porphyrins and phthalocyanines which are low-molecular-weight conjugated compounds. The electron-donating organic material may be a donor-acceptor linked material having an electron-donating moiety and an electron-accepting moiety in a molecule thereof.

The number average molecular weight (Mn) of the electron-donating organic material is preferably 10,000 or lower and more preferably 5,000 or lower when the electron-donating organic material is a low-molecular-weight material. It is preferably 10,000 or higher when the electron-donating organic material is a polymer.

One preferable example of the electron-donating organic material is an organic material having a highest occupied molecular orbital (HOMO) level of 5.1 eV or higher but 5.5 eV or lower and a number average molecular weight (Mn) of 10,000 or lower. Such an organic material is, for example, a compound represented by General Formula (1) below.

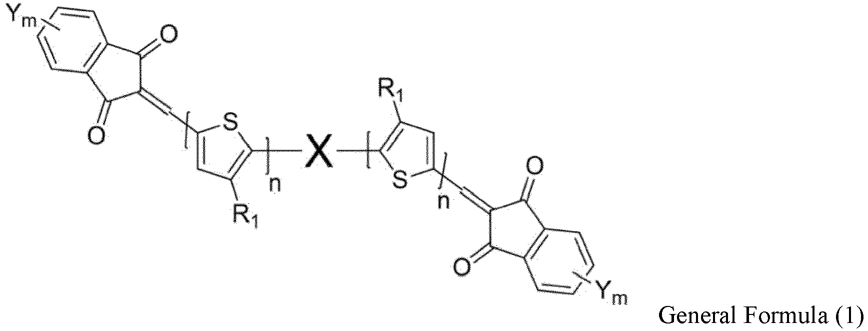

In the above General Formula (1), R₁ represents an alkyl group having carbon atoms of 2 or more but 8 or less.

In the above General Formula (1), n represents an integer of 1 or greater but 3 or smaller.

In the above General Formula (1), Y represents a halogen atom.

In the above General Formula (1), m represents an integer of 0 or greater but 4 or smaller.

In the above General Formula (1), X represents General Formula (2) below or General Formula (3) below.

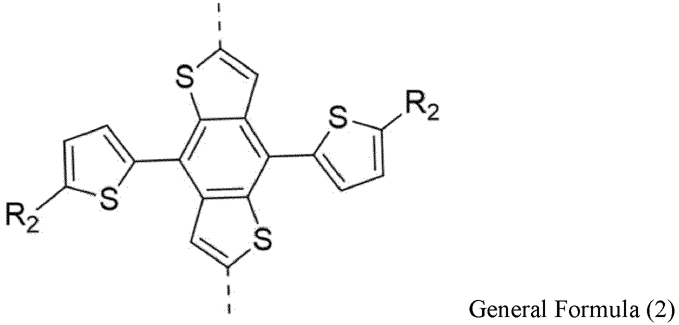

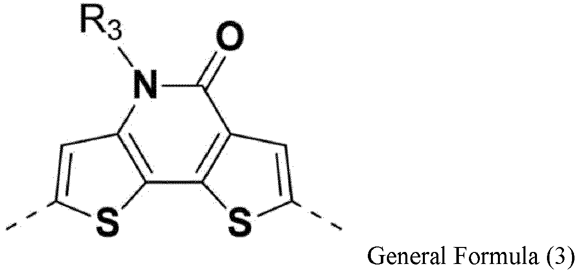

In the above General Formula (2), R₂ represents a straight-chain or branched alkyl group and is preferably a straight-chain or branched alkyl group having carbon atoms of 2 or more but 30 or less.

In the above General Formula (3), R₃ represents a straight-chain or branched alkyl group and is preferably a straight-chain or branched alkyl group having carbon atoms of 2 or more but 30 or less.

Another preferable example of the electron-donating organic material is an organic material having a highest occupied molecular orbital (HOMO) level of 5.2 eV or higher but 5.6 eV or lower and a number average molecular weight (Mn) of 10,000 or higher. This organic material is preferably used in combination with the above organic material having a highest occupied molecular orbital (HOMO) level of 5.1 eV or higher but 5.5 eV or lower and a number average molecular weight (Mn) of 10,000 or lower.

Examples of the organic material having a highest occupied molecular orbital (HOMO) level of 5.2 eV or higher but 5.6 eV or lower and a number average molecular weight (Mn) of 10,000 or higher include, but are not limited to, 2,1,3-benzothiadiazole-thiophene-based copolymers, quinoxaline-thiophene-based copolymers, thiophene-benzodithiophene-based copolymers, and polyfluorene-based polymers.

The 2,1,3-benzothiadiazole-thiophene-based copolymer is a conjugated copolymer having, in a main chain, a thiophene backbone and a 2,1,3-benzothiadiazole backbone. Specific examples of the 2,1,3-benzothiadiazole-thiophene-based copolymer include, but are not limited to, those represented by General Formulae (5) to (8) below. In the General Formulae (5) to (8) below, n each independently represents an integer of 1 or greater but 1,000 or smaller.

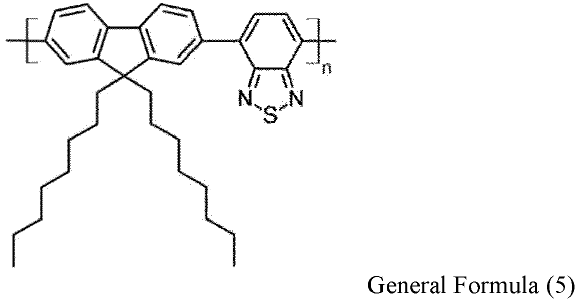

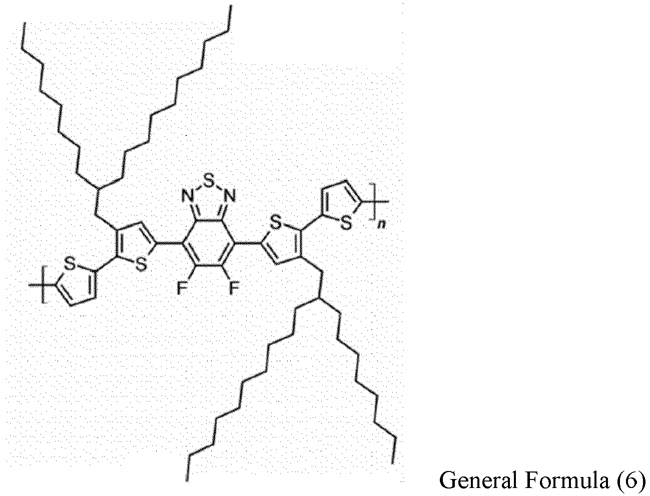

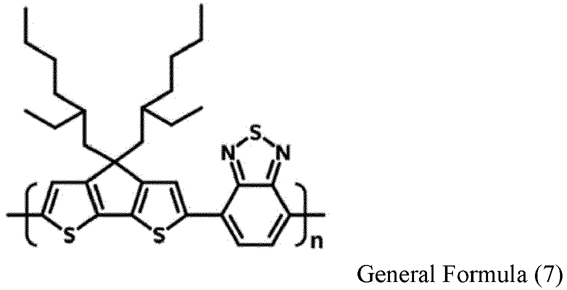

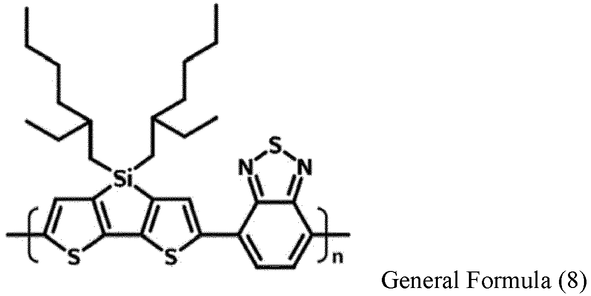

The quinoxaline-thiophene-based copolymer is a conjugated copolymer having, in a main chain, a thiophene backbone and a quinoxaline backbone. Specific examples of the quinoxaline-thiophene-based copolymer include, but are not limited to, those represented by General Formula (9) below. In the General Formula (9) below, n represents an integer of 1 or greater but 1,000 or smaller.

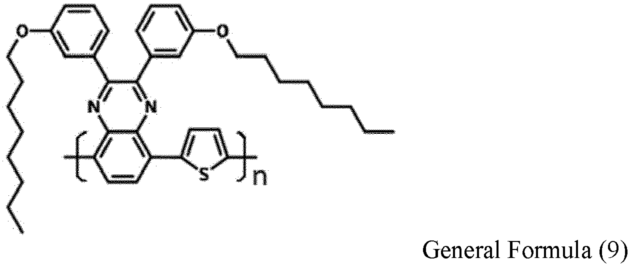

The thiophene-benzodithiophene-based copolymer is a conjugated copolymer having, in a main chain, a thiophene backbone and a benzodithiophene backbone. Specific examples of the thiophene-benzodithiophene-based copolymer include, but are not limited to, those represented by General Formulae (10) to (13) below. In the General Formulae (10) to (13) below, n each independently represents an integer of 1 or greater but 1,000 or smaller.

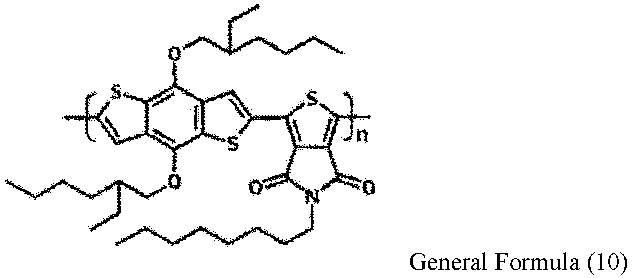

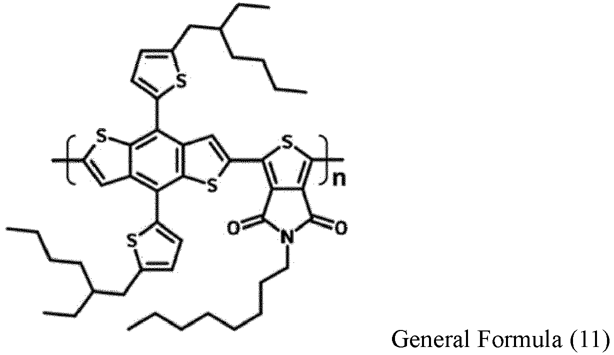

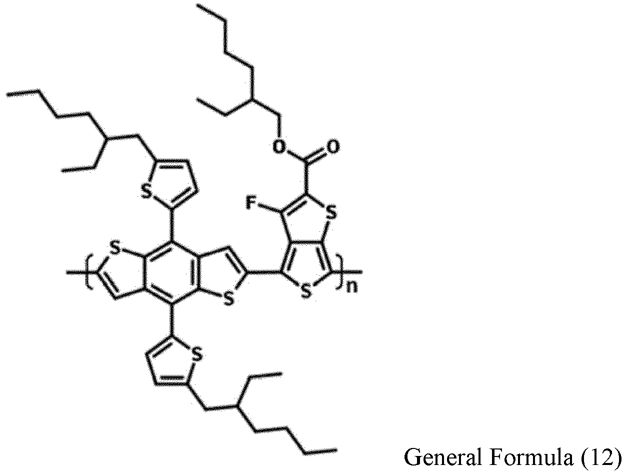

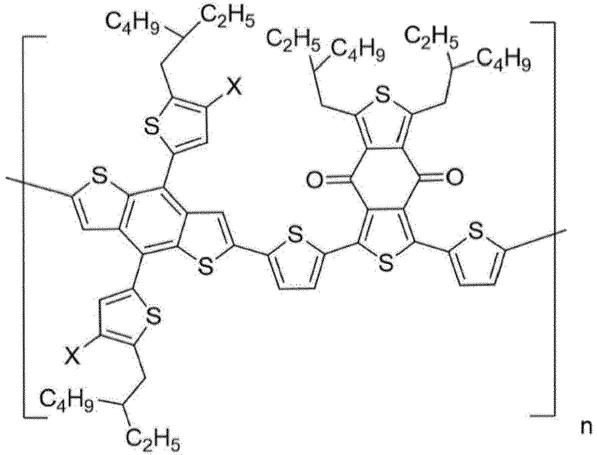

X=H, F, Cl, Br, I General Formula (13)

### -Electron-accepting organic material-

The electron-accepting organic material is preferably a π-electron conjugated compound having a lowest unoccupied molecular orbital (LUMO) level of 3.5 eV or higher but 4.5 eV or lower.

Examples of the electron-accepting organic material include, but are not limited to, fullerenes or derivatives thereof, naphthalene tetracarboxylic acid imide derivatives, and perylene tetracarboxylic acid imide derivatives. Of these, fullerene derivatives are preferable.

Examples of the fullerene derivatives include, but are not limited to, C₆₀, phenyl-C₆₁-methyl butyrate (fullerene derivatives described as PCBM, [60]PCBM, or PC₆₁BM in, for example, some publicly known documents), C₇₀, phenyl-C₇₁-methyl butyrate (fullerene derivatives described as PCBM, [70]PCBM, or PC₇₁BM in, for example, some publicly known documents), and fulleropyrrolidine-based fullerene derivatives represented by General Formula (14) below. The fulleropyrrolidine-based fullerene derivatives represented by General Formula (14) below are preferable.

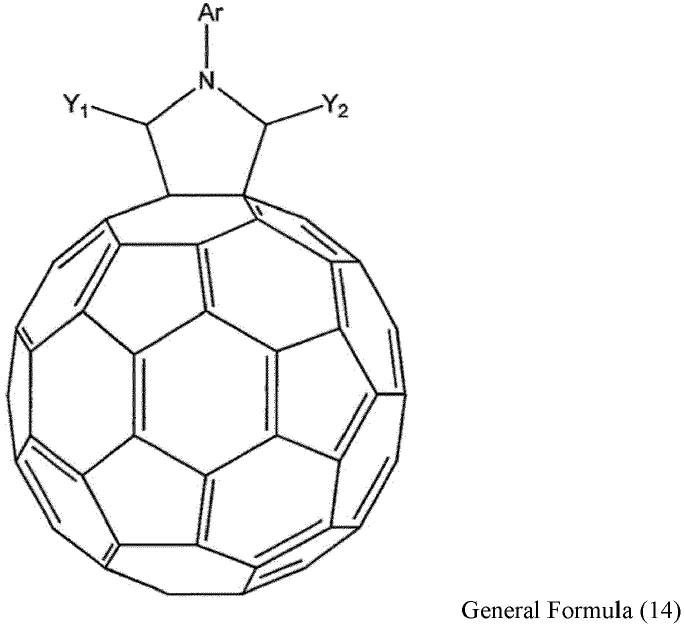

In the above General Formula (14), Y₁ and Y₂ each independently represent a hydrogen atom, an alkyl group, an alkenyl group, an alkynyl group, an aryl group, or an aralkyl group, provided that Y₁ and Y₂ are not a hydrogen atom at the same time. The alkyl group, the alkenyl group, the alkynyl group, the aryl group, or the aralkyl group may have or may not have a substituent.

The alkyl group represented by Y₁ and Y₂ is preferably an alkyl group having carbon atoms of 1 or more but 22 or less, more preferably an alkyl group having carbon atoms of 1 or more but 12 or less, and further preferably an alkyl group having carbon atoms of 6 or more but 12 or less. These alkyl groups may be straight-chain or branched but are preferably straight-chain. The alkyl group may further contain one or more heteroatoms such as S and O in the carbon chain thereof.

The alkenyl group represented by Y₁ and Y₂ is preferably an alkenyl group having carbon atoms of 2 or more but 10 or less. More preferable specific examples thereof include, but are not limited to, straight-chain or branched alkenyl groups having carbon atoms of 2 or more but 4 or less, such as a vinyl group, a 1-propenyl group, an allyl group, an isopropenyl group, a 1-betene group, a 2-butenyl group, a 3-butenyl group, a 1-methyl-2-propenyl group, and a 1,3-butadienyl group.

The alkynyl group represented by Y₁ and Y₂ is preferably an alkynyl group having carbon atoms of 1 or more but 10 or less. More preferable specific examples thereof include, but are not limited to, straight-chain or branched alkynyl groups having carbon atoms of 2 or more but 4 or less, such as an ethynyl group, a 1-propynyl group, a 2-propenyl group, a 1-methyl-2-propynyl group, a 1-butynyl group, a 2-butynyl group, and a 3-butynyl group.

Examples of the aryl group represented by Y₁ and Y₂ include, but are not limited to, a phenyl group, a naphthyl group, an anthranyl group, and a phenanthryl group.

Examples of the aralkyl group represented by Y₁ and Y₂ include, but are not limited to, aralkyl groups having carbon atoms of 7 or more but 20 or less, such as 2-phenylethyl, benzyl, 1-phenylethyl, 3-phenylpropyl, and 4-phenylbutyl.

When the alkyl group, the alkenyl group, the alkynyl group, the aryl group, or the aralkyl group represented by Y₁ and Y₂ has a substituent, specific examples of the substituent include, but are not limited to, an alkyl group, an alkoxycarbonyl group, a polyether group, an alkanoyl group, an amino group, an aminocarbonyl group, an alkoxy group, an alkylthio group, group: -CONHCOR' (where R' is an alkyl group), group: -C(=NR')-R" (where R' and R" are an alkyl group), and group: -NR'=CR"R"' (where R', R", and R‴ are an alkyl group).

Of the substituents represented by Yi and Y₂, the polyether group exemplified is a group represented by, for example, formula: Y₃-(OY₄)ₙ-O-. In this formula, Y₃ is a monovalent hydrocarbon group such as an alkyl group and Y₄ is a divalent aliphatic hydrocarbon group. In the polyether group represented by the above formula, specific examples of the repeating unit -(OY₄)ₙ- include, but are not limited to, alkoxy chains such as - (OCH₂)ₙ-, -(OC₂H₄)ₙ-, and -(OC₃H₆)ₙ-. The number n of the repeating units is preferably 1 or greater but 20 or smaller and more preferably 1 or greater but 5 or smaller. The repeating unit represented by -(OY₄)ₙ- may contain not only the same repeating units but also two or more kinds of different repeating units. Of the above repeating units, -OC₂H₄- and -OC₃H₆-may be straight-chain or branched.

In the substituents represented by Yi and Y₂, the alkyl group and an alkyl group moiety in the alkoxycarbonyl group, the alkanoyl group, the alkoxy group, the alkylthio group, the polyether group, the group: -CONHCOR', the group: -C(=NR')-R", and the group: -NR'=CR"R"' are preferably an alkyl group having carbon atoms of 1 or more but 22 or less, more preferably an alkyl group having carbon atoms of 1 or more but 12 or less, and further preferably an alkyl group having carbon atoms of 6 or more but 12 or less.

In the substituents represented by Yi and Y₂, the amino group and an amino group moiety in the aminocarbonyl group are preferably amino groups to which one or more alkyl groups each having carbon atoms of 1 or more but 20 or less are bonded.

In the above General Formula (14), Ar represents an aryl group, provided that the aryl group may have or may not have a substituent.

Examples of the aryl group represented by Ar include, but are not limited to, a phenyl group, a naphthyl group, an anthranyl group, a phenanthryl group. Of these, a phenyl group is preferable.

When the aryl group represented by Ar has a substituent, specific examples of the substituent include, but are not limited to, aryl groups, alkyl groups, a cyano group, alkoxy groups, and alkoxycarbonyl groups. Examples of the aryl groups as the substituent include, but are not limited to, a phenyl group. The alkyl group and an alkyl group moiety in the alkoxy group in these substituents are preferably an alkyl group having carbon atoms of 1 or more but 22 or less. The number and positions of these substituents are not particularly limited. For example, 1 or more but 3 or less substituents can be present at any positions.

### -Average thickness of the photoelectric conversion layer-

The average thickness of the photoelectric conversion layer is preferably 50 nm or more but 400 nm or less and more preferably 60 nm or more but 250 nm or less. When the average thickness thereof is 50 nm or more, a sufficient number of carriers are generated by the photoelectric conversion layer through light absorption. When the average thickness thereof is 400 nm or less, reduction in transportation efficiency of carriers generated through light absorption is prevented.

The average thickness of the photoelectric conversion layer is calculated by measuring the thickness of the photoelectric conversion layer at 9 randomly selected points in the following manner, for example, and by determining the average of the measurements obtained. First, a liquid containing materials forming the photoelectric conversion layer is applied on a base and dried, and then a solvent is used to wipe off the resultant at any points. Using DEKTAK available from Bruker Corporation, the heights of the level differences at the wiped sites, and the average value of the obtained measurements is defined as the average thickness. Alternatively, the cross-section of the photoelectric conversion element may be observed under a scanning electron microscope (SEM) or a transmission electron microscope (TEM) to measure the average thickness of the photoelectric conversion layer.

### -Method for forming a bulk heterojunction in the photoelectric conversion layer-

The photoelectric conversion layer may be formed by sequentially stacking layers of the above organic materials as a layer having a planar junction interface. In order to enlarge the area of the junction interface, preferably, the above organic materials are three-dimensionally mixed to form a bulk heterojunction. The bulk heterojunction is formed in the following manner, for example.

When the organic materials have high solubility, the bulk heterojunction is formed by dissolving the organic materials in a solvent to prepare a solution where the organic materials are mixed at a molecular level, and by applying the solution and then drying to remove the solvent. In this case, a heating treatment may further be performed to optimize the aggregated state of the organic materials.

When the organic materials have low solubility, the bulk heterojunction is formed by dissolving one of the organic materials to prepare a solution and dispersing another one of the organic materials in the solution to prepare a liquid, and by applying the liquid and then drying to remove the solvent. In this case, a heating treatment may further be performed to optimize the aggregated state of the organic materials.

### -Method for forming the photoelectric conversion layer-

A method for forming the photoelectric conversion layer includes a step of applying the liquid containing the above organic materials. Examples of a method of applying the liquid include, but are not limited to, spin coating, blade coating, slit die coating, screen printing coating, bar coater coating, mold coating, print transfer, dipping and pulling, inkjet, spraying, and vacuum vapor deposition. An actually used method can be appropriately selected therefrom depending on the properties of a photoelectric conversion layer intended to be produced; i.e., in consideration of, for example, thickness control and orientation control.

For spin coating, for example, it is preferable to use a solution containing the organic materials at a concentration of 5 mg/mL or more but 40 mg/mL or less. Here, the concentration refers to the total mass of the organic materials relative to the volume of the solution containing the organic materials. In the above range of concentration, it is possible to easily form a homogeneous photoelectric conversion layer.

In order to remove the solvent or dispersion medium from the applied liquid containing the organic materials, an annealing treatment may be performed under reduced pressure or in an inert atmosphere (in a nitrogen or argon atmosphere). The temperature of the annealing treatment is preferably 40°C or higher but 300°C or lower and more preferably 50°C or higher but 150°C or lower. Performing the annealing treatment is preferable because the materials forming the layers can permeate each other at the interface between the stacked layers to have an increased contact area, which may be able to increase the short circuit current.

Examples of the solvent or dispersion medium for dissolving or dispersing the organic materials include, but are not limited to, methanol, ethanol, butanol, toluene, xylene, o-chlorophenol, acetone, ethyl acetate, ethylene glycol, tetrahydrofuran, dichloromethane, chloroform, dichloroethane, chlorobenzene, dichlorobenzene, trichlorobenzene, ortho-dichlorobenzene, chloronaphthalene, dimethylformamide, dimethyl sulfoxide, N-methylpyrrolidone, and γ-butyrolactone. These may be used alone or in combination. Of these, chlorobenzene, chloroform, and ortho-dichlorobenzene are particularly preferable.

Various additives may be contained in the above solvent or dispersion medium. Examples of the various additives for use include, but are not limited to, diiodooctane and octanedithiol.

### <Hole transporting layer>

The "hole transporting layer" is a layer configured to transport holes generated in the photoelectric conversion layer and prevent entry of electrons generated in the photoelectric conversion layer. In the configuration, one hole transporting layer may be present or two or more hole transporting layers may be present. As one example, the following is described about the configuration including one hole transporting layer.

The hole transporting layer is preferably a layer containing at least one selected from the group consisting of organic compounds having hole transportability and inorganic compounds having hole transportability. Examples of the organic compounds having hole transportability include, but are not limited to: conductive polymers such as polyethylenedioxythiophene:polystyrene sulfonic acid (PEDOT:PSS); and aromatic amine derivatives. Examples of the inorganic compounds having hole transportability include, but are not limited to, molybdenum oxide, tungsten oxide, vanadium oxide, nickel oxide, and copper(I) oxide. Of these compounds having hole transportability, molybdenum oxide, tungsten oxide, and vanadium oxide are preferable.

The average thickness of the hole transporting layer is preferably 200 nm or less and more preferably 1 nm or more but 50 nm or less.

Examples of a method for forming the hole transporting layer include, but are not limited to, a method of applying and then drying a liquid containing the compound having hole transportability and a solvent or dispersion medium. Examples of a method of applying the liquid include, but are not limited to, spin coating, the sol-gel method, slit die coating, and sputtering.

### <Second electrode>

The "second electrode" is an electrode configured to collect holes generated through photoelectric conversion. When the second electrode is provided on the light incident surface side, the second electrode is preferably high in light transmission and more preferably transparent from the viewpoint of increasing photoelectric conversion efficiency. When the second electrode is provided on the opposite side to the light incident surface, light transmission and transparency may be low.

The second electrode may be the same electrode as the above first electrode, and description therefor will be omitted.

### <Surface protection layer (passivation layer)>

The "surface protection layer" is a layer configured to prevent direct contact between the sealing member and the electrode provided on the opposite side to the light incident surface. The surface protection layer may be a member provided so as to prevent direct contact between the sealing member and an exposed surface of each of the layers stacked, in addition to the electrode provided on the opposite side to the light incident surface. The surface protection layer may also be referred to as a passivation layer.

Examples of the material of the surface protection layer include: but are not limited to: metal oxides such as SiOx, SiOxNy, and Al₂O₃; and polymers such as polyethylene, fluorine-based coating agents, and poly-para-xylylene. These may be used alone or in combination. Of these, metal oxides or fluorine-based coating agents are preferable.

The average thickness of the surface protection layer is preferably 1 nm or more but 10 µm or less.

Examples of a method for forming the surface protection layer include, but are not limited to, vacuum vapor deposition, sputtering, reactive sputtering, molecular beam epitaxy (MBE), plasma CVD, laser CVD, thermal CVD, gas-source CVD, coating, printing, and transferring.

### <Sealing member>

The "sealing member" is a member that is configured to prevent entry of external substances such as water and oxygen into the photoelectric conversion element (specifically, into a space formed by at least the sealing member and the other electrode) to contact each of the above layers. The sealing member preferably has a gas barrier member that prevents entry of external substances into the photoelectric conversion element or an adhesive member that adheres to an adhesion region in the other electrode. The sealing member is more preferably a film member having these members that are combined together as one single member. The sealing member is provided to cover one of the electrodes. When the sealing member is provided on the opposite side to the light incident surface, the sealing member may or may not have light transmittivity or transparency.

The function required for the gas barrier member is typically represented by, for example, a water vapor transmission rate or an oxygen transmission rate. Preferably, the water vapor transmission rate per day according to the method stipulated by JIS K7129 B is, for example, 1 × 10⁻² g/m² or lower, and the lower it is, the more preferable. Preferably, the oxygen transmission rate per day according to the method stipulated by JIS K7126-2 is, for example, 1 cm³/m²·atm or lower, and the lower it is, the more preferable.

Examples of the material of the gas barrier member include, but are not limited to, a metal foil, a film obtained by stacking a layer of a resin material on a metal foil, a film having a structure where a layer of an inorganic material such as SiO₂ and a layer of an organic material are stacked, and glass.

The material of the adhesive member may be, for example, a typical material that is used for sealing of, for example, organic electroluminescence elements and organic transistors. Specific examples of the material of the adhesive member include, but are not limited to, pressure-sensitive adhesive resins, thermosetting resins, thermoplastic resins, and photocurable resins. Of these, pressure-sensitive adhesive resins or resins that can adhere by heating at low temperatures are preferable because there is no need for heating at a sealing step. More specific examples thereof include, but are not limited to, epoxy-based resins, polyolefin-based resins, ethylene-vinyl acetate copolymer resins, styrene-isobutylene resins, polyester-based resins, acrylic-based resins, urethane-based resins, and silicone-based resins. From the viewpoint of increasing adhesiveness, epoxy-based resins or polyolefin-based resins are preferable. By, for example, chemical modification of the main chain, branched chains, and terminals of these resins, and adjustment of molecular weights thereof, various adhesion properties can be obtained. The adhesive member may contain, for example, a hygroscopic material or hydrotalcite, in addition to the above resins.

### <UV cut layer>

The "UV cut layer" is a layer that is provided on the light incident surface side and configured to prevent degradation of the photoelectric conversion element due to UV light. The UV cut layer is preferably a film member that absorbs UV light. The UV cut layer is preferably provided on the base located on the light incident surface side.

The function required for the UV cut layer is typically represented by, for example, light transmittance. Preferably, the light transmittance of light having a wavelength of 370 nm or shorter is, for example, lower than 1%. Preferably, the light transmittance of light having a wavelength of 410 nm or shorter is, for example, lower than 1%.

### <Gas barrier layer>

The "gas barrier layer" is a layer configured to prevent entry of external substances such as water and oxygen into the photoelectric conversion element. The gas barrier layer is preferably a continuous film. The gas barrier layer is preferably provided adjacent to the base and is more preferably provided between the other electrode and the base. In the present disclosure, when the gas barrier layer is provided adjacent to the base, the gas barrier layer is regarded as a constituent that constitutes the base.

The function required for the gas barrier layer is typically represented by, for example, a water vapor transmission rate or an oxygen transmission rate. Preferably, the water vapor transmission rate per day according to the method stipulated by JIS K7129 B is, for example, 1 × 10⁻² g/m² or lower, and the lower it is, the more preferable. Preferably, the oxygen transmission rate per day according to the method stipulated by JIS K7126-2 is, for example, 1 cm³/m²·atm or lower, and the lower it is, the more preferable.

Examples of the material of the gas barrier layer include, but are not limited to: materials containing SiO₂, SiNx, Al₂O₃, SiC, SiCN, SiOC, and SiOAl; and siloxane-based materials.

### <Other layers>

If necessary, the photoelectric conversion element may further include other layers such as an insulating porous layer, a degradation preventing layer, and a protection layer.

### <Configuration of photoelectric conversion element>

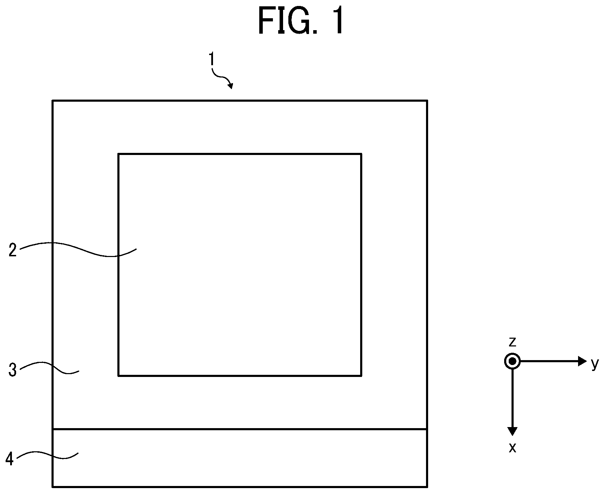

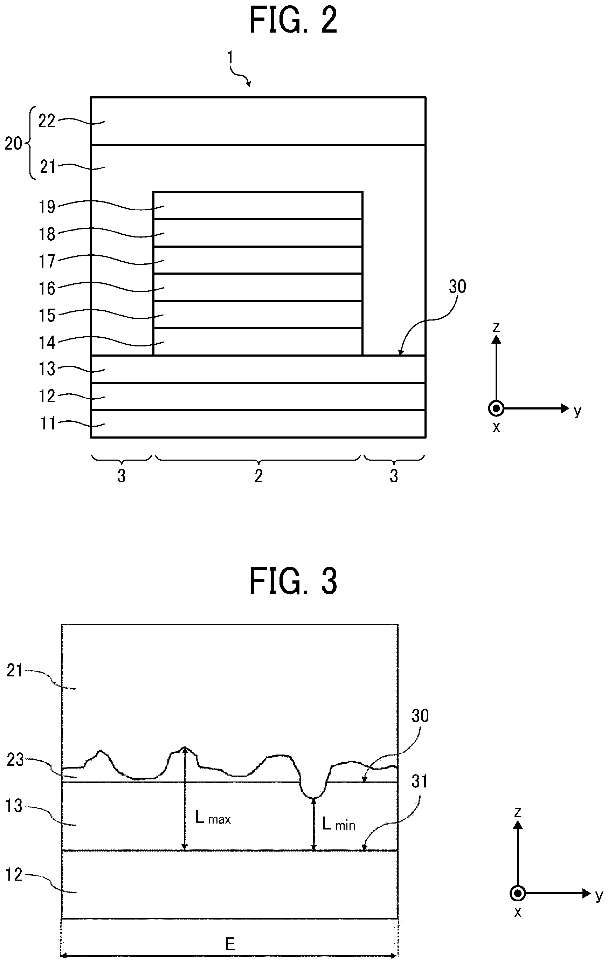

One example of the configuration of the photoelectric conversion element will be described with reference to FIGs. 1 and 2. FIG. 1 is a schematic diagram illustrating one example of the photoelectric conversion element as viewed from the above. FIG. 2 is a schematic cross-sectional diagram illustrating one example of the photoelectric conversion element.

As illustrated in the schematic diagram of FIG. 1, a photoelectric conversion element 1 includes a photoelectric conversion region 2 where photoelectric conversion is possible, a seal region 3 surrounding the photoelectric conversion region 2, and the other region 4 where the other members such as a terminal are provided.

As illustrated in the schematic cross-sectional diagram of FIG. 2, a photoelectric conversion element 1 has a structure where a UV cut layer 11, a base 12, a first electrode 13, a first electron transporting layer 14, a second electron transporting layer (an intermediate layer) 15, a photoelectric conversion layer 16, a hole transporting layer 17, a second electrode 18, a surface protection layer (a passivation layer) 19, and a sealing member 20 are stacked in the photoelectric conversion region 2 along a stacking direction z in the order from the side of the light incident surface (hereinafter this structure may also be referred to as "Structure A"). In the seal region 3, the photoelectric conversion element 1 has the UV cut layer 11, the base 12, the first electrode 13, and the sealing member 20 that are stacked along the stacking direction z in the order from the side of the light incident surface. The sealing member 20 has an adhesive member 21 and a gas barrier member 22. Also, the sealing member 20 encloses the first electron transporting layer 14, the second electron transporting layer (the intermediate layer) 15, the photoelectric conversion layer 16, the hole transporting layer 17, the second electrode 18, and the surface protection layer (the passivation layer) 19 and adheres to an adhesion region 30 in the first electrode 13. In the photoelectric conversion element 1, the first electrode 13 corresponds to the above "other electrode" and the second electrode 18 corresponds to the above "one electrode". The photoelectric conversion element 1 may further include, for example, a coupling portion in which the photoelectric conversion element 1 is electrically coupled to another photoelectric conversion element in series or in parallel. The stacking direction z is a direction perpendicular to the face of each layer (xy-plane) in the photoelectric conversion element.

In the photoelectric conversion region 2 of the photoelectric conversion element 1 having Structure A, the order in which from the first electrode 13 to the second electrode 18 are stacked is not limited to this order, as described above. Specifically, the photoelectric conversion element 1 may have a structure where a UV cut layer 11, a base 12, a second electrode 13, a hole transporting layer 14, a photoelectric conversion layer 15, a second electron transporting layer (an intermediate layer) 16, a first electron transporting layer 17, a first electrode 18, a surface protection layer (a passivation layer) 19, and a sealing member 20 are stacked in the photoelectric conversion region 2 along a stacking direction z in the order from the side of the light incident surface (hereinafter this structure may also be referred to as "Structure B"). The sealing member 20 encloses the hole transporting layer 14, the photoelectric conversion layer 15, the second electron transporting layer (the intermediate layer) 16, the first electron transporting layer 17, the first electrode 18, the surface protection layer (the passivation layer) 19 and adheres to an adhesion region 30 in the second electrode 13. In the photoelectric conversion element 1, the second electrode 13 corresponds to the above "other electrode" and the first electrode 18 corresponds to the above "one electrode".

In the present disclosure, description will be mainly made taking as an example the photoelectric conversion element having the Structure A as illustrated in FIGs. 1 and 2. However, persons skilled in the art could easily understand from such descriptions the photoelectric conversion element having the Structure B.

Next, the way the sealing member 20 adheres to the first electrode 13 (the other electrode) will be described with reference to FIG. 3. FIG. 3 is a schematic cross-sectional view of the structure of the photoelectric conversion element in the vicinity of the adhesion region.

As illustrated in the schematic cross-sectional diagram of FIG. 3 in which the vicinity of the adhesion region 30 is enlarged, the adhesive member 21 of the sealing member 20 and the first electrode 13 (the other electrode) directly or indirectly contact and adhere to each other. The ideal way the adhesive member 21 adheres to the first electrode 13 (the other electrode) is a way the adhesive member 21 directly contacts and adheres to the first electrode 13 (the other electrode), which is preferable. Actually, however, as illustrated in FIG. 3, the adhesive member 21 may indirectly adhere to the first electrode 13 (the other electrode) via attached matter 23 derived from, for example, the material having formed any layer, due to a certain factor in the production process of the photoelectric conversion element 1. Even if the adhesive member 21 directly adheres to the first electrode 13 (the other electrode), as illustrated in FIG. 3, the adhesive member 21 may adhere to a partially scraped recessed portion in the first electrode 13 (the other electrode) due to a certain factor in the production process of the photoelectric conversion element 1. When recessed and protruded portions are present at the adhesion interface between the adhesive member 21 and the first electrode 13 (the other electrode), it becomes more likely to form portions where the adhesive member 21 has difficulty in sufficiently adhering to the first electrode 13 (the other electrode), leading to a decrease in the sealing performance of the sealing member 20. As a result, when the photoelectric conversion element is placed in a high-temperature, high-humidity environment for a long period of time, the photoelectric conversion efficiency thereof decreases.

An effective way to increase the sealing performance of the sealing member 20 is adjusting, in a cross-section of the photoelectric conversion element 1 in the stacking direction z, the difference between the maximum value Lₘₐₓ and the minimum value Lₘᵢₙ of a length L to 1,000 nm or less, where the length L is a length in the stacking direction z from a face 31 of the first electrode 13 (the other electrode) where the adhesion region 30 is absent to the sealing member 21 that adheres to the adhesion region 30. The difference therebetween is preferably adjusted to 500 nm or less and more preferably adjusted to 100 nm or less. When it is 1,000 nm or less, the extent of the recessed and protruded portions becomes smaller at the adhesion interface between the adhesive member 21 and the first electrode 13 (the other electrode), leading to an increase in the sealing performance of the sealing member 20. Meanwhile, the difference between the maximum value Lₘₐₓ and the minimum value Lₘᵢₙ of the length L is 20 nm or more. When it is 20 nm or more, the recessed and protruded portions cause an anchor effect between the adhesive member 21 and the first electrode 13 (the other electrode), leading to an increase in the sealing performance of the sealing member 20.

The cross-section of the photoelectric conversion element 1 in the stacking direction z is prepared so as to include the seal region 3 (in a range including the adhesion region 30). The length L is measured within an evaluation interval E that is set to have a length of 2.5 µm in a direction (e.g., γ-direction) perpendicular to the stacking direction z in the cross-section. That is, the maximum value of the length L in the evaluation interval E is Lₘₐₓ and the minimum value of the length L in the evaluation interval E is Lₘᵢₙ, and the above difference is calculated from these Lₘₐₓ and Lₘᵢₙ. When in the evaluation interval E, there is a gap at the adhesion interface between the adhesive member 21 and the first electrode 13 (the other electrode), the length L is defined as a length obtained by subtracting the length of the gap in the stacking direction z from the length from the face 31 to the sealing member 21 in the stacking direction z. The evaluation interval E is set in a region that is 100 µm or more inner than the outer periphery of the seal region 3 and 100 µm or more inner than the inner periphery of the seal region 3. As the above difference, an average value of differences calculated in three or more different evaluation intervals is employed.

When the difference between the maximum value Lₘₐₓ and the minimum value Lₘᵢₙ of the length L is 1,000 nm or less, as described above, the photoelectric conversion element is prevented from decreasing in photoelectric conversion efficiency even if placed in a high-temperature, high-humidity environment for a long period of time. Being prevented from decreasing in photoelectric conversion efficiency specifically means that the retention rate of the photoelectric conversion efficiency is 80% or more when the photoelectric conversion element is subjected to a test where the photoelectric conversion element is left to stand still for 500 hours in an environment of 40°C and 90%Rh. The retention rate of the photoelectric conversion efficiency is a proportion of the photoelectric conversion efficiency after the test relative to the photoelectric conversion efficiency before the test.

### «Photoelectric conversion module»

The "photoelectric conversion module" includes a plurality of photoelectric conversion elements that are electrically coupled to each other. Regarding the electrical coupling, the photoelectric conversion elements may be coupled in series or in parallel. The photoelectric conversion module may include both a plurality of photoelectric conversion elements that are electrically coupled in series and a plurality of photoelectric conversion elements that are electrically coupled in parallel. In the present disclosure, the "coupling" in each occurrence shall not be limited to a physical coupling and shall include an electrical coupling as well.

The photoelectric conversion module includes a plurality of photoelectric conversion elements and a coupling portion configured to electrically couple the plurality of photoelectric conversion elements to each other; and if necessary, includes other members. In other words, the photoelectric conversion module includes a first photoelectric conversion element, a second photoelectric conversion element, and a coupling portion configured to electrically couple the first photoelectric conversion element and the second photoelectric conversion element to each other; and if necessary, includes other members. The photoelectric conversion element and the coupling portion may be functionally distinguishable members. The photoelectric conversion element and the coupling portion may be independent members. Alternatively, the photoelectric conversion elements and the coupling portion may be a continuously or integrally provided member. For example, the electrode, as one constituting member of the photoelectric conversion element, and the coupling portion may be independent members or may be a continuously or integrally provided member.

### «Methods for producing photoelectric conversion element and photoelectric conversion module»

One example of a method for producing a photoelectric conversion module will be described while referring to one example of a method for producing a photoelectric conversion element. In the present disclosure, one example of a method for producing a photoelectric conversion element having the Structure A as illustrated in FIG. 2 will be described. However, persons skilled in the art could easily understand from the below-given description one example of a method for producing a photoelectric conversion element having the Structure B.

The method for producing the photoelectric conversion module including the photoelectric conversion element includes, for example: a gas barrier layer forming step of forming a gas barrier layer on a base; a first electrode forming step of forming a first electrode on the base including the gas barrier layer; an electron transporting layer forming step of forming an electron transporting layer on the first electrode; a photoelectric conversion layer forming step of forming a photoelectric conversion layer on the electron transporting layer; a penetrating portion forming step of forming a penetrating portion that penetrates the electron transporting layer and the photoelectric conversion layer; a hole transporting layer forming step of forming a hole transporting layer on the photoelectric conversion layer and coating exposed surfaces of the first electrode, the electron transporting layer, and the photoelectric conversion layer in the penetrating portion with a material of the hole transporting layer; a second electrode forming step of forming a second electrode on the hole transporting layer and filling the penetrating portion with a material of the second electrode to form a penetrating structure; a surface protection layer forming step of forming a surface protection layer on the second electrode; an adhesion region forming step of removing a peripheral portion of a stack of from the electron transporting layer to the surface protection layer, to form an adhesion region in the first electrode; and a sealing member forming step of allowing a sealing member to enclose the stack of from the electron transporting layer to the surface protection layer and contact the adhesion region. If necessary, the method includes, for example, a UV cut layer forming step and other steps.

### <Gas barrier layer forming step>

The method for producing the photoelectric conversion module including the photoelectric conversion element preferably includes a gas barrier layer forming step of forming a gas barrier layer on a base. When the base itself has gas barrier property, formation of the gas barrier layer is optional.

### <First electrode forming step>

The method for producing the photoelectric conversion module including the photoelectric conversion element preferably includes a first electrode forming step of forming a first electrode on the base including the gas barrier layer. When the base does not include a gas barrier layer, the first electrode is may be formed on the base.

A method of forming the first electrode is as described in the description regarding the first electrode.

### <Electron transporting layer forming step>

The method for producing the photoelectric conversion module including the photoelectric conversion element preferably includes an electron transporting layer forming step of forming an electron transporting layer on the first electrode. When a first electron transporting layer and a second electron transporting layer (an intermediate layer) are included as the electron transporting layer, the electron transporting layer forming step preferably includes a first electron transporting layer forming step of forming the first electron transporting layer on the first electrode and a second electron transporting layer forming step of forming the second electron transporting layer on the first electron transporting layer.

A method of forming the electron transporting layer is as described in the description regarding the electron transporting layer.

### <Photoelectric conversion layer forming step>

The method for producing the photoelectric conversion module including the photoelectric conversion element preferably includes a photoelectric conversion layer forming step of forming a photoelectric conversion layer on the electron transporting layer.

A method of forming the photoelectric conversion layer is as described in the description regarding the photoelectric conversion layer.

### <Penetrating portion forming step>

The method for producing the photoelectric conversion module including the photoelectric conversion element preferably includes a penetrating portion forming step of forming a penetrating portion that penetrates the electron transporting layer and the photoelectric conversion layer. In the present disclosure, the penetrating portion is a vacant pore. In the photoelectric conversion element having the Structure A as illustrated in FIG. 2, the penetrating portion is a vacant pore that penetrates the electron transporting layer and the photoelectric conversion layer. The shape, size, etc. of the penetrating portion are not limited as long as the photoelectric conversion elements can be electrically coupled to each other. Examples of the shape thereof include, but are not limited to, shapes that become a line or circle when the plan view of the photoelectric conversion module is observed from the second electrode thereof. Further examples of the shape thereof include, but are not limited to, shapes that become a rectangle or square when the cross-section of the photoelectric conversion element is observed. The penetrating portion divides each of the layers to form a plurality of photoelectric conversion elements.

Examples of a method of forming the penetrating portion include, but are not limited to, laser deletion and mechanical scribing.

### <Hole transporting layer forming step>

The method for producing the photoelectric conversion module including the photoelectric conversion element preferably includes a hole transporting layer forming step of forming a hole transporting layer on the photoelectric conversion layer and coating exposed surfaces of the first electrode, the electron transporting layer, and the photoelectric conversion layer in the penetrating portion with a material of the hole transporting layer.

A method of forming the hole transporting layer is as described in the description regarding the hole transporting layer.

### <Second electrode forming step>

The method for producing the photoelectric conversion module including the photoelectric conversion element preferably includes a second electrode forming step of forming a second electrode on the hole transporting layer and filling the penetrating portion with a material of the second electrode to form a penetrating structure. In the present disclosure, the penetrating structure is a structure that fills the interior of the penetrating portion. In the photoelectric conversion module having the Structure A as illustrated in FIG. 2, the penetrating structure is a structure formed of the material of the hole transporting layer and the material of the second electrode. This penetrating structure functions as a coupling portion configured to couple the photoelectric conversion elements to each other.

A method for forming the second electrode is as described in the description regarding the second electrode.

### <Surface protection layer forming step>

The method for producing the photoelectric conversion module including the photoelectric conversion element preferably includes a surface protection layer forming step of forming a surface protection layer on the second electrode.

### <Adhesion region forming step>

The method for producing the photoelectric conversion module including the photoelectric conversion element preferably includes an adhesion region forming step of removing a peripheral portion of a stack of from the electron transporting layer to the surface protection layer (i.e., a stack of the electron transporting layer, the photoelectric conversion layer, the hole transporting layer, the second electrode, and the surface protection layer), to expose the first electrode to form an adhesion region on the first electrode.

Examples of a method for removing the peripheral portion include, but are not limited to, laser deletion and mechanical scribing. The removal of the peripheral portion may form attached matter 23 derived from, for example, the material having formed any layer, a partially scraped recessed portion in the first electrode 13 (the other electrode), etc., as illustrated in FIG. 3. This results in formation of the recessed and protruded portions at the adhesion interface between the adhesive member and the first electrode (the other electrode) and it becomes more likely to form portions where the adhesive member has difficulty in sufficiently adhering to the first electrode (the other electrode), leading to a decrease in the sealing performance of the sealing member. As a result, when the photoelectric conversion element is placed in a high-temperature, high-humidity environment for a long period of time, the photoelectric conversion efficiency thereof decreases.

As described above, an effective way to overcome this is adjusting, in a cross-section of the photoelectric conversion element in the stacking direction, the difference between the maximum value and the minimum value of the length L to 1,000 nm or less, where the length L is a length in the stacking direction z from the face of the first electrode (the other electrode) where the adhesion region is absent to the sealing member that adheres to the adhesion region. A method of forming the adhesion interface that satisfies the above configuration is not particularly limited, but one example thereof is a method using a laser beam having a wavelength of 355 nm at a power of 10 mW, a pitch of processing of 40 µm, a frequency of 5 kHz, and a speed of 80 mm/s.

### <Sealing member forming step>

The method for producing the photoelectric conversion module including the photoelectric conversion element may include a sealing member forming step of allowing a sealing member to enclose the stack of from the electron transporting layer to the surface protection layer (i.e., the stack of the electron transporting layer, the photoelectric conversion layer, the hole transporting layer, the second electrode, and the surface protection layer) and contact the adhesion region to adhere thereto. The sealing member forming step may be preformed by applying the adhesive member followed by attaching the gas barrier member on the adhesive member or by attaching the gas barrier member to which the adhesive member has been applied in advance.

The sealing member encloses the above stack in the photoelectric conversion element. As described in the present production method, a possible embodiment is that the sealing member enclosing the photoelectric conversion module results in enclosing the above stack. In other words, a possible embodiment is not limited to the embodiment where the above stack is enclosed in each photoelectric conversion element.

### <UV cut layer forming step>

The method for producing the photoelectric conversion module including the photoelectric conversion element may, if necessary, include a UV cut layer forming step of forming a UV cut layer on the light incident surface side.

### <Other steps>

The method for producing the photoelectric conversion module including the photoelectric conversion element may, if necessary, include an insulating porous layer forming step, a degradation preventing layer forming step, and a protection layer forming step.

### <Specific examples of the methods for producing the photoelectric conversion element and the photoelectric conversion module>

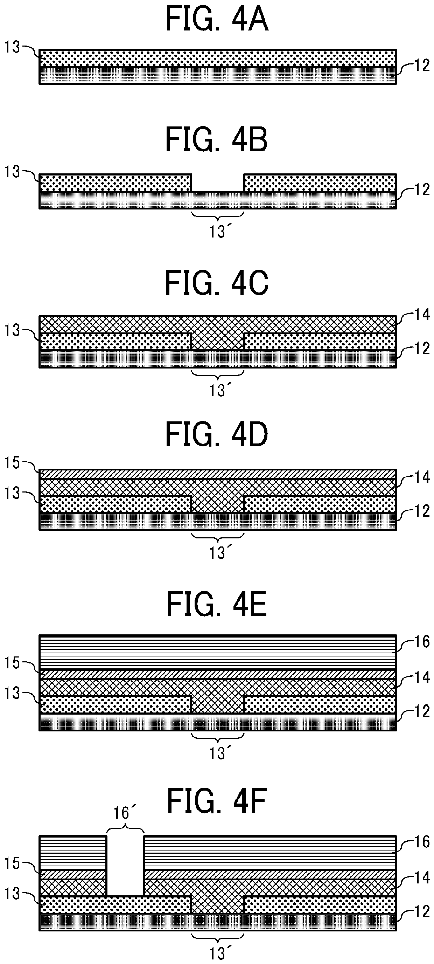

Referring to FIG. 4A to FIG. 4M, one example of the method for producing the photoelectric conversion module including the photoelectric conversion element will be described in detail. FIG. 4A to FIG. 4M are schematic diagrams each illustrating the method for producing the photoelectric conversion module.

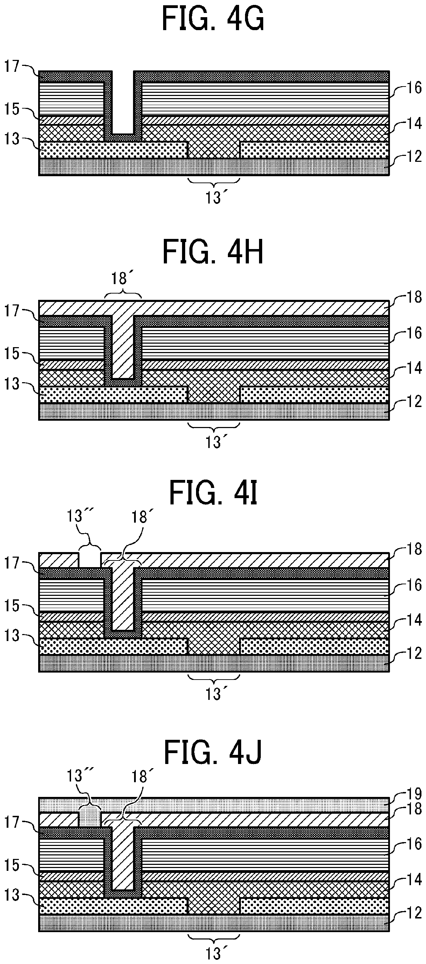

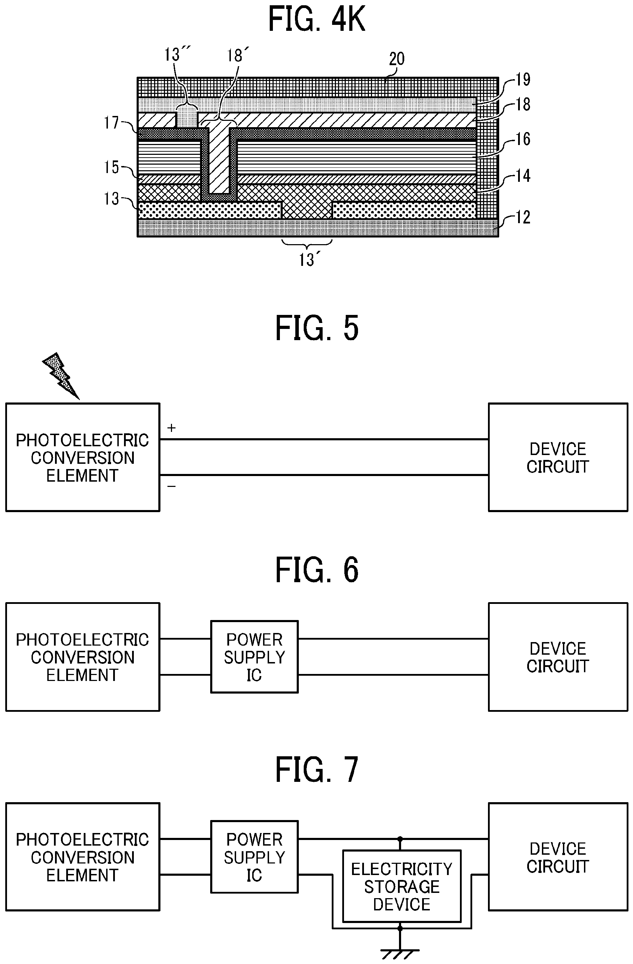

As illustrated in FIG. 4A, first, a first electrode 13 is formed on a base 12 having gas barrier property. When forming a plurality of photoelectric conversion elements on one base 12, as illustrated in FIG. 4B, part of the formed first electrode 13 is deleted to form a first partition portion 13'. Next, as illustrated in FIG. 4C and FIG. 4D, a first electron transporting layer 14 is formed on the base 12 and the first electrode 13, and a second electron transporting layer (an intermediate layer) 15 is formed on the first electron transporting layer 14. Next, as illustrated in FIG. 4E, a photoelectric conversion layer 16 is formed on the formed second electron transporting layer 15. After the formation of the photoelectric conversion layer 16, as illustrated in FIG. 4F, a penetrating portion 16' is formed by removing a predetermined region so as to penetrate the first electron transporting layer 14 formed on the first electrode 13, the second electron transporting layer 15 formed on the first electron transporting layer 14, and the photoelectric conversion layer 16. After the formation of the penetrating portion 16', as illustrated in FIG. 4G and FIG. 4H, a hole transporting layer 17 and a second electrode 18 are formed. After the formation of the hole transporting layer 17 and the second electrode 18, a coupling portion 18' is formed that is a structure formed in the penetrating portion 16' of the material of the hole transporting layer and the material of the second electrode. When forming a plurality of photoelectric conversion elements on one base 12, as illustrated in FIG. 4I, a second partition portion 13" is formed in the second electrode 18. Next, as illustrated in FIG. 4J, a surface protection layer 19 is formed on the second electrode 18. Next, as illustrated in FIG. 4K, the first electrode 13 is exposed by removing the peripheral portion in the stack of from the electron transporting layer 14 to the surface protection layer 19, to expose the first electrode 13 to form an adhesion region on the first electrode 13. Further, a sealing member 20 is allowed to enclose the stack of from the electron transporting layer to the surface protection layer and to contact the adhesion region to adhere thereto.

### «Electronic device»

An electronic device includes the above photoelectric conversion element (which may be a photoelectric conversion module including a plurality of photoelectric conversion elements) and a device that is electrically coupled to the photoelectric conversion element. The device that is electrically coupled to the photoelectric conversion element is a device configured to be driven by, for example, electric power generated through photoelectric conversion of the photoelectric conversion element. The electronic device has two or more different embodiments depending on applications thereof. Examples of the embodiments include, but are not limited to, the following first and second embodiments.

The first embodiment is an electronic device including the photoelectric conversion element and the device that is electrically coupled to the photoelectric conversion element; and if necessary, including other devices.

The second embodiment is an electronic device including the photoelectric conversion element, a storage cell that is electrically coupled to the photoelectric conversion element, and a device that is electrically coupled to the photoelectric conversion element and the storage cell; and if necessary, including other devices.

### <<Power supply module»

A power supply module includes the above photoelectric conversion element and a power supply integrated circuit (IC) that is electrically coupled to the photoelectric conversion element; and if necessary, includes other devices.

### «Applications»

The above photoelectric conversion element can function as a self-sustaining power supply and drive a device using electric power generated through photoelectric conversion. Since the photoelectric conversion element can generate electricity by irradiation with light, it is not necessary to couple an electronic device to an external power supply or replace a cell. The electronic device can be driven in a place where there is no power supply facility. The electronic device can be worn or carried. The electronic device can be driven without replacement of a cell even in a place where the cell is difficult to replace. When a dry cell is used in an electronic device, the electronic device becomes heavier by the weight of the dry cell, or the electronic device becomes larger by the size of the dry cell. There may be a problem in installing the electronic device on a wall or ceiling, or carrying the electronic device. However, since the photoelectric conversion element is lightweight and thin, it can be highly freely installed and be worn and carried, which is advantageous.

The photoelectric conversion element can be used as a self-sustaining power supply, and can be incorporated into various electronic devices in use. Examples of applications of the electronic devices that incorporate the photoelectric conversion element include, but are not limited to: display devices, such as electronic desk calculators, watches, mobile phones, electronic organizers, and electronic paper; accessory devices of personal computers, such as mice for personal computers or keyboards for personal computers; various sensor devices, such as temperature and humidity sensors and human detection sensors; transmitters, such as beacons or global positioning systems (GPSs); auxiliary lightings; and remote controllers.

The photoelectric conversion element of the present disclosure can generate electricity even with light of a low illuminance. The low illuminance is, for example, an illuminance as seen in an indoor environment irradiated with, for example, a lighting. Specifically, the low illuminance is an illuminance of 20 lx or higher but 1,000 lx or lower, and is much lower than direct sunlight (about 100,000 lx). The photoelectric conversion element has a wide variety of applications because it can generate electricity even in indoor environments and in further darker shaded areas. The photoelectric conversion element is highly safe because liquid leakage found in the case of a dry cell does not occur, and accidental swallowing found in the case of a button cell does not occur. The photoelectric conversion element can be used as an auxiliary power supply for the purpose of prolonging a continuous operation time of a charge-type or dry cell-type electrical appliance. When the photoelectric conversion element is combined with a device configured to be driven by electric power generated through photoelectric conversion of the photoelectric conversion element, it is possible to obtain an electronic device that is lightweight and easy to use, has a high degree of freedom in installation, does not require replacement, is excellent in safety, and is effective in reducing environmental load. The electronic device that incorporates the photoelectric conversion element can be used for a variety of applications.

FIG. 5 is a schematic diagram illustrating one example of a basic configuration of the electronic device obtained by combining the photoelectric conversion element with the device that is configured to be driven by electric power generated through photoelectric conversion of the photoelectric conversion element. The electronic device can generate electricity when the photoelectric conversion element is irradiated with light, and electric power can be taken out. A circuit of the device can be driven by the generated electric power.

Since the output of the photoelectric conversion element varies depending on the illuminance of the surroundings, the electronic device illustrated in FIG. 5 cannot sometimes be stably driven. In this case, as illustrated in FIG. 6, which is a schematic diagram illustrating one example of a basic configuration of the electronic device, a power supply IC is preferably incorporated between the photoelectric conversion element and the circuit of the device to supply stable voltage to a side of the circuit of the device.

The photoelectric conversion element can generate electricity as long as the photoelectric conversion element is irradiated with light having a sufficient illuminance. However, when the illuminance is not enough to generate electricity, desired electric power cannot be obtained, which is a disadvantage of the photoelectric conversion element. In this case, as illustrated in FIG. 7, which is a schematic diagram illustrating one example of a basic configuration of the electronic device, when an electricity storage device such as a capacitor is provided between a power supply IC and a device circuit, excess electric power from the photoelectric conversion element can be charged to the electricity storage device. Even when the illuminance is too low or light is not applied to the photoelectric conversion element, the electric power stored in the electricity storage device can be supplied to a device circuit to allow for stable operation of the device circuit.

The electronic device obtained by combining the photoelectric conversion element with the device circuit can be driven even in an environment without a power supply, does not require replacement of a cell, and can be stably driven, when combined with a power supply IC or an electricity storage device. The electronic device that incorporates the photoelectric conversion element can be used for a variety of applications.

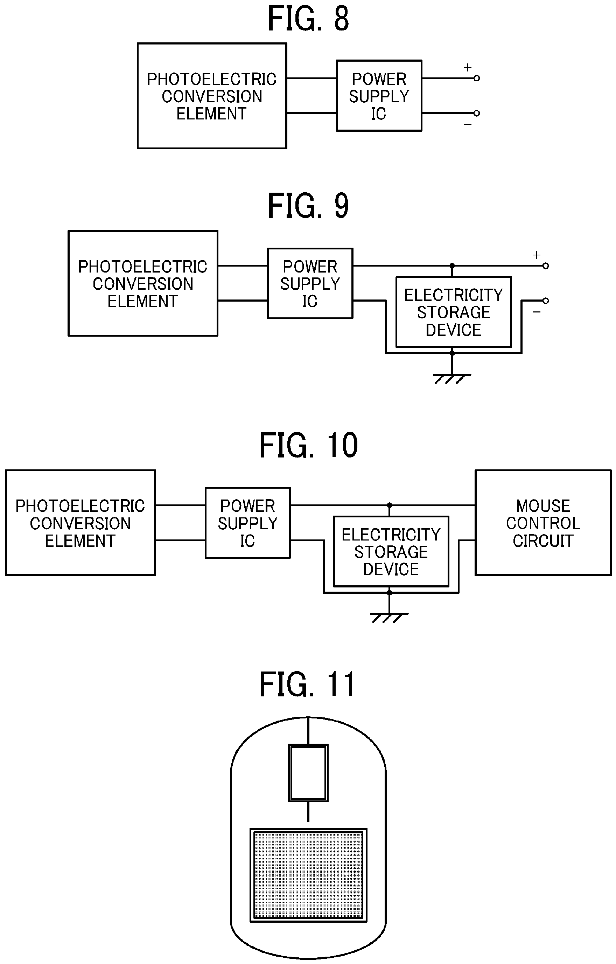

The photoelectric conversion element can also be used as a power supply module. As illustrated in FIG. 8, which is a schematic diagram illustrating one example of a basic configuration of a power supply module, for example, when the photoelectric conversion element and a power supply IC are coupled to each other, it is possible to configure a direct current power supply module, which is capable of supplying electric power generated through photoelectric conversion of the photoelectric conversion element to the power supply IC at a predetermined voltage level.

As illustrated in FIG. 9, which is a schematic diagram illustrating one example of a basic configuration of a power supply module, when an electricity storage device is added to a power supply IC, electric power generated by the photoelectric conversion element can be charged to the electricity storage device. It is possible to configure a power supply module capable of supplying electric power even when the illuminance is too low or light is not applied to the photoelectric conversion element.

The power supply modules illustrated in FIG. 8 and FIG. 9 can be used as a power supply module without replacement of a cell like in traditional primary cells. The electronic device that incorporates the photoelectric conversion element can be used for a variety of applications.

Now, specific applications of the electronic device including the above photoelectric conversion element and the device configured to be driven by electric power will be described.

### <Application as mouse for personal computer>

FIG. 10 is a schematic diagram illustrating one example of a basic configuration of a mouse for a personal computer (hereinafter may also be referred to as a "mouse"). As illustrated in FIG. 10, the mouse includes the photoelectric conversion element, a power supply IC, an electricity storage device, and a mouse control circuit. As a power supply for the mouse control circuit, electric power is supplied from the coupled photoelectric conversion element or electricity storage device. With this configuration, electricity can be charged to the electricity storage device when the mouse is not used, and the mouse can be driven by the charged electric power. The mouse thus obtainable does not require any wiring or replacement of a cell. The mouse can become lightweight because a cell is not required. This is suitable as an application as a mouse.

FIG. 11 is a schematic outside diagram illustrating one example of the mouse for a personal computer illustrated in FIG. 10. As illustrated in FIG. 11, the photoelectric conversion element, the power supply IC, the electricity storage device, and the mouse control circuit are mounted inside the mouse. Meanwhile, the upper part of the photoelectric conversion element is covered with a transparent cover so that light hits the photoelectric conversion element. The whole casing of the mouse can also be shaped from a transparent resin. The arrangement of the photoelectric conversion element is not limited to this. For example, the photoelectric conversion element may be located anywhere as long as light hits the photoelectric conversion element even when the mouse is covered with a hand. <Application as keyboard for a personal computer>

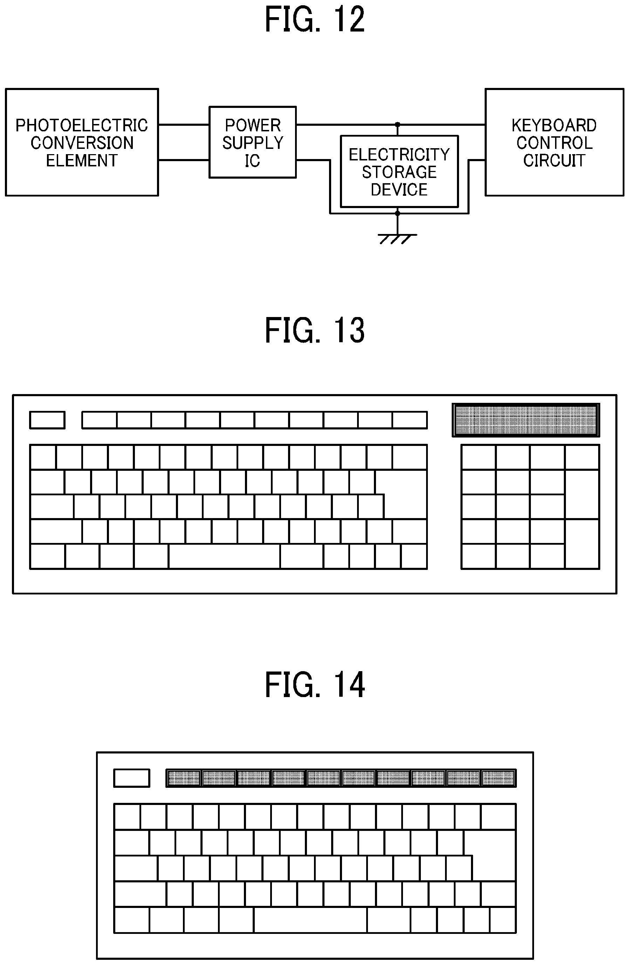

FIG. 12 is a schematic diagram illustrating one example of a basic configuration of a keyboard for a personal computer (hereinafter may also be referred to as a "keyboard"). As illustrated in FIG. 12, the keyboard includes the photoelectric conversion element, a power supply IC, an electricity storage device, and a keyboard control circuit. As a power supply for the keyboard control circuit, electric power is supplied from the coupled photoelectric conversion element or electricity storage device. With this configuration, electricity can be charged to the electricity storage device when the keyboard is not used, and the keyboard can be driven by the charged electric power. The keyboard thus obtainable does not require any wiring or replacement of a cell. The keyboard can become lightweight because a cell is not required. This is suitable as an application as a keyboard.

FIG. 13 is a schematic outside diagram illustrating one example of the keyboard for a personal computer illustrated in FIG. 12. As illustrated in FIG. 13, the photoelectric conversion element, the power supply IC, the electricity storage device, and the mouse control circuit are mounted inside the keyboard. Meanwhile, the upper part of the photoelectric conversion element is covered with a transparent cover so that light hits the photoelectric conversion element. The whole casing of the keyboard can also be shaped from a transparent resin. The arrangement of the photoelectric conversion element is not limited to this. For example, in the case of a compact keyboard with a small space for the photoelectric conversion element, as illustrated in FIG. 14, which is a schematic outside diagram illustrating another example of the keyboard for a personal computer illustrated in FIG. 12, a compact photoelectric conversion element can be embedded in parts of the keys.

### <Application as sensor>

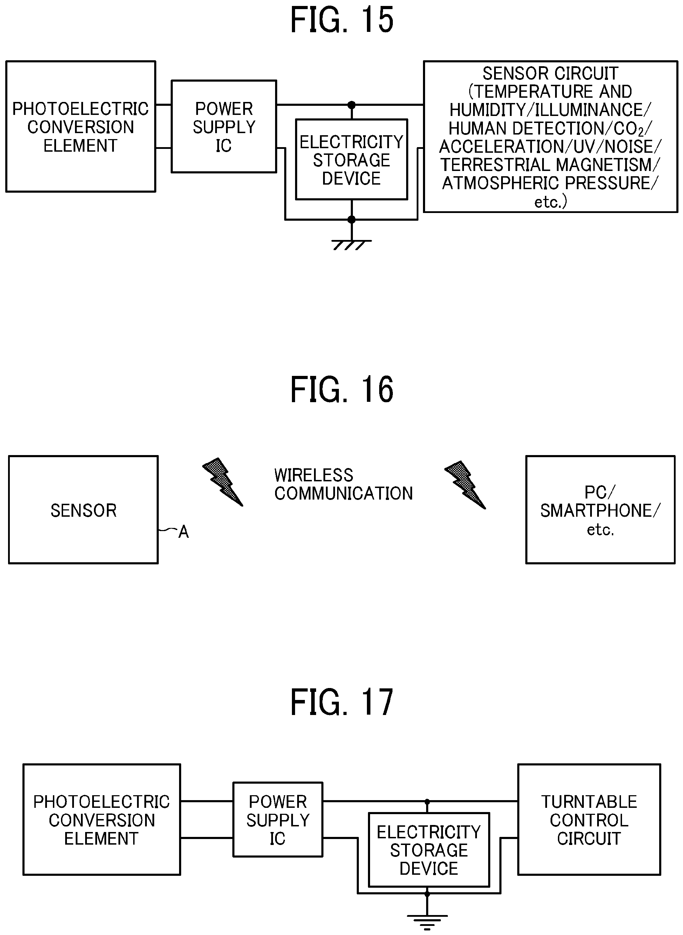

FIG. 15 is a schematic diagram illustrating one example of a basic configuration of a sensor as one example of the electronic device. As illustrated in FIG. 15, the sensor includes the photoelectric conversion element, a power supply IC, an electricity storage device, and a sensor circuit. As a power supply for the sensor, electric power is supplied from the coupled photoelectric conversion element or electricity storage device. This makes it possible to configure a sensor that does not require coupling to an external power supply or replacement of a cell. Examples of a sensing target of the sensor include, but are not limited to, temperature and humidity, illuminance, human detection, CO₂, acceleration, UV, noise, terrestrial magnetism, and atmospheric pressure. As illustrated in "A" in FIG. 16, the sensor is preferably configured to sense a measurement target on a regular basis and to transmit the read data to, for example, a personal computer (PC) or a smartphone through wireless communication.

It is expected that use of sensors will be significantly increased in response to realization of the internet of things (IoT) society. Replacing cells of numerous sensors one by one takes a lot of effort and is not realistic. Sensors installed at positions where cells are not easy to replace, such as a ceiling and a wall, make workability low. The fact that electricity can be supplied by the photoelectric conversion element is significantly advantageous. The photoelectric conversion element of the present disclosure has such advantages that a high output can be obtained even with light of a low illuminance, and a high degree of freedom in installation can be achieved because dependency of the output on the light incident angle is small.

### <Application as turntable>

FIG. 17 is a schematic diagram illustrating one example of a basic configuration of a turntable as one example of the electronic device. As illustrated in FIG. 17, the turntable includes the photoelectric conversion element, a power supply IC, an electricity storage device, and a turntable control circuit. As a power supply for the turntable control circuit, electric power is supplied from the coupled photoelectric conversion element or electricity storage device. This makes it possible to configure a turntable that does not require coupling to an external power supply or replacement of a cell. The turntable is used in, for example, a display case in which products are displayed. Wirings of a power supply degrade appearance of the display. Displayed products need removing when replacing a cell, which takes a lot of effort. The turntable to which electric power can be supplied by the photoelectric conversion element is significantly advantageous.

### Examples

The present disclosure will be described below by way of Examples. However, the present disclosure should not be construed as being limited to the Examples.

### (Example 1)

### <Production of photoelectric conversion module>

### -Base with first electrode-

First, a polyethylene terephthalate (PET) base (50 mm×50 mm) with a gas barrier layer having a patterned film of indium-doped tin oxide (ITO) was procured from GEOMATEC Co., Ltd. As illustrated in FIG. 4B, a first partition portion is formed in the first electrode.

### -Formation of first electron transporting layer-

Next, a liquid of zinc oxide nanoparticles (obtained from Aldrich Co., average particle diameter: 12 nm) was spin-coated at 3,000 rpm on the ITO gas barrier PET film (15 S2/sq.), followed by drying at 100°C for 10 minutes, to form an electron transporting layer having an average thickness of 30 nm.

### -Formation of second electron transporting layer (intermediate layer)-

Next, dimethylaminobenzoic acid (obtained from Tokyo Chemical Industry Co., Ltd.) was dissolved in ethanol to prepare a 1 mg/ml solution. The solution was spin-coated at 3,000 rpm on the first electron transporting layer, to form a second electron transporting layer having an average thickness of less than 10 nm.

### -Formation of photoelectric conversion layer-

Exemplary Compound 1 presented below (number average molecular weight (Mn)=1,554, highest occupied molecular orbital (HOMO) level: 5.13 eV) (15 mg) and Exemplary Compound 3 presented below (10 mg) were dissolved in 1 mL of chloroform, to prepare photoelectric conversion layer coating liquid A.

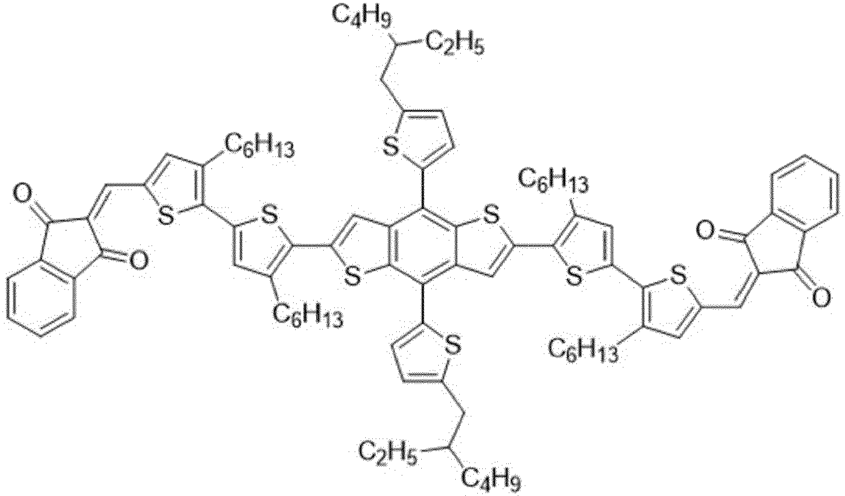

### Exemplary Compound 1

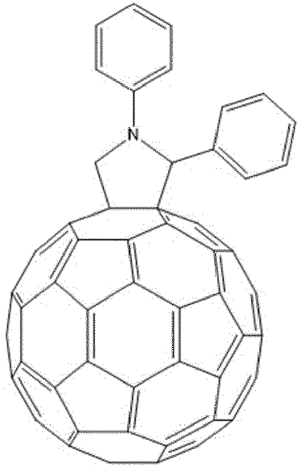

### Exemplary Compound 3

Next, the photoelectric conversion layer coating liquid A was spin-coated at 600 rpm on the intermediate layer, to form a photoelectric conversion layer having an average thickness of 220 nm.

### -Formulation of penetrating portion-

Next, a penetrating portion was formed in a pre-step of forming a coupling portion, which was to couple photoelectric conversion elements in series. The penetrating portion was formed (by deletion) using laser deletion. The shape of the penetrating portion was a rectangle when the plan view of the photoelectric conversion module was observed from a second electrode thereof.

### -Formation of hole transporting layer, second electrode, and coupling portion-

Next, the material of a hole transporting layer; i.e., molybdenum oxide (obtained from PURE CHEMICAL CO., LTD.) in an average thickness of 50 nm and the material of a second electrode; i.e., silver in an average thickness of 100 nm were sequentially vapor-deposited in vacuum on the photoelectric conversion layer and in the penetrating portion, to thereby form the hole transporting layer, the second electrode, and the coupling portion. As illustrated in FIG. 4I, a second partition portion was formed in the second electrode.

### -Formation of surface protection layer-

Next, the material of a surface protection layer; i.e., a fluorine coating agent (obtained from HARVES Co., Ltd.) was spin-coated at 1,000 rpm on the second electrode, to form a surface protection layer.

### -Formation of seal region-

Next, the peripheral portion (width: 3 mm) of the formed stack of from the electron transporting layer to the surface protection layer was removed using a laser cutter (obtained from TOWA LASERFRONT CORPORATION) to expose the first electrode to form an adhesion region on the first electrode. The output, pitch of processing, frequency, and speed in the laser irradiation conditions were adjusted so that the difference between the maximum value Lₘₐₓ and the minimum value Lₘᵢₙ of length L would be 100 nm.

### -Formation of sealing member-

A sealing member formed by combining an adhesive member of a polyolefin-based resin (obtained from MORESCO Corporation) and an Al/PET stacked gas barrier member (obtained from Toyo Aluminium K.K.) as one single member was disposed so as to enclose the formed stack of from the electron transporting layer to the surface protection layer and adhere to the adhesion region on the first electrode, followed by adhesion using a vacuum laminator (obtained from JOYO ENGINEERING CO., LTD.) at a pressure of 0.2 MPa.

### -Measurement of the difference between maximum value Lₘₐₓ and minimum value Lₘᵢₙ of length L-

In the seal region of the photoelectric conversion module formed, an ion milling machine (obtained from Hitachi High-Tech Corporation) was used to prepare a cross-section including the stacking direction. Next, in an almost central portion of the cross-section, three different sites were set as evaluation intervals (length: 2.5 µm each). Each of the evaluation intervals was observed under a scanning electron microscope (SEM, obtained from ZEISS) to measure length L and then calculate the difference between the maximum value Lₘₐₓ and the minimum value Lₘᵢₙ. Further, the average value of the differences between the maximum values Lₘₐₓ and the minimum values Lₘᵢₙ in the evaluation intervals was calculated. Results are presented in Table 1.

### -Calculation of retention rate of photoelectric conversion efficiency-

First, each of the photoelectric conversion elements constituting the photoelectric conversion module formed was measured for current-voltage characteristics under white LED irradiation (color temperature: 5,000 K, illuminance: 200 lx). A current-voltage curve obtained was used to calculate photoelectric conversion efficiency. In the measurement, a white LED light used was a bulb-shaped LED lamp (LDA11N-G/40W, obtained from Toshiba Lighting & Technology Corporation) and an evaluation device (sourcemeter) used was KETSIGHT B2902A. Measurement of the output of the LED light source was made using spectrum color illumination meter C-7000 obtained from SEKONIC COPORATION.

Next, the photoelectric conversion module formed was left to stand still for 500 hours in a constant temperature and humidity test chamber of 40°C and 90%Rh. After that, the photoelectric conversion module was taken out from the constant temperature and humidity test chamber, and was measured for current-voltage characteristics in the same manner as described above. A current-voltage curve obtained was used to calculate photoelectric conversion efficiency.

The above-calculated values were used to calculate the retention rate of the photoelectric conversion efficiency; i.e., a proportion of the photoelectric conversion efficiency after the constant temperature and humidity test relative to the photoelectric conversion efficiency before the constant temperature and humidity test. Results are presented in Table1. The retention rate of the photoelectric conversion efficiency is determined from the formula: "the retention rate of the photoelectric conversion efficiency = (the photoelectric conversion efficiency after the constant temperature and humidity test / the photoelectric conversion efficiency before the constant temperature and humidity test) × 100".

### (Example 2)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 350 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 3)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 500 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 4)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 550 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 5)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 800 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 6)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 7)

### <Production of photoelectric conversion module>

A photoelectric conversion module was produced in the same manner as in the production of the photoelectric conversion module of Example 6, except that the sealing member was changed to a sealing member (obtained from tesa tape K.K.) which was formed by combining an adhesive member of an epoxy-based resin with an Al/PET stacked gas barrier member as one single member.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 8)

### <Production of photoelectric conversion module>

A photoelectric conversion module was produced in the same manner as in the production of the photoelectric conversion module of Example 6, except that the sealing member was changed to a sealing member (obtained from tesa tape K.K.) which was formed by combining an adhesive member of an acryl-based resin with an Al/PET stacked gas barrier member as one single member.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 9)

### <Production of photoelectric conversion module>

A photoelectric conversion module was produced in the same manner as in the production of the photoelectric conversion module of Example 6, except that the sealing member was changed to a sealing member (obtained from tesa tape K.K.) which was formed by combining an adhesive member of a silicone-based resin with an Al/PET stacked gas barrier member as one single member.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 10)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid B prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid B-

The following Exemplary Compound 2 (number average molecular weight (Mn)=1,463, highest occupied molecular orbital (HOMO) level: 5.27 eV) (16 mg) and the following Exemplary Compound 3 (10 mg) were dissolved in 1 mL of chloroform, to prepare photoelectric conversion layer coating liquid B.

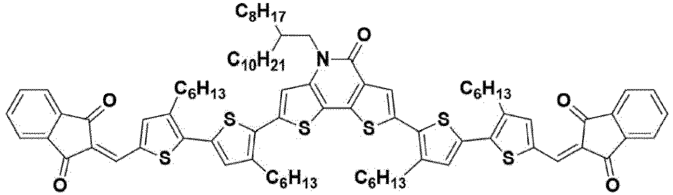

### Exemplary Compound 2

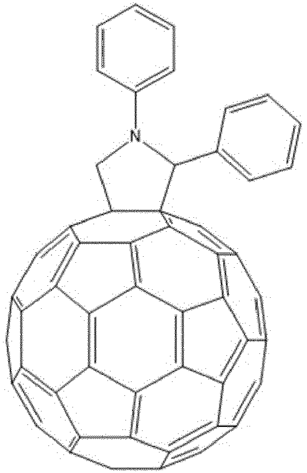

### Exemplary Compound 3

### (Example 11)

### <Production of photoelectric conversion module>

A photoelectric conversion module was produced in the same manner as in the production of the photoelectric conversion module of Example 10, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 12)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid C prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid C-

The following Exemplary Compound 4 (number average molecular weight (Mn)=2,029, highest occupied molecular orbital (HOMO) level: 5.50 eV) (16 mg) and the following Exemplary Compound 3 (10 mg) were dissolved in 1 mL of chloroform, to prepare photoelectric conversion layer coating liquid C.

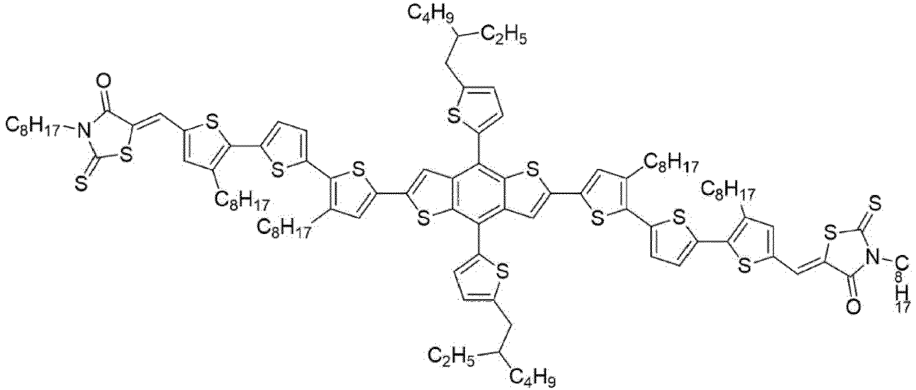

### Exemplary Compound 4

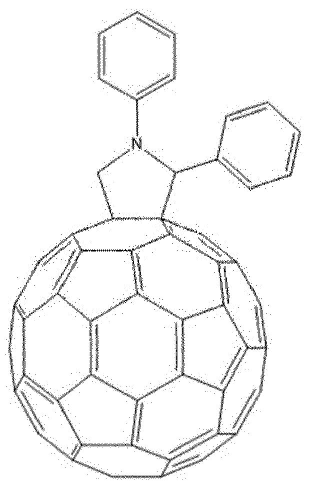

### Exemplary Compound 3

### (Example 13)

### <Production of photoelectric conversion module>

A photoelectric conversion module was produced in the same manner as in the production of the photoelectric conversion module of Example 12, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 14)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid D prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid D-

The above Exemplary Compound 1 (number average molecular weight (Mn)=1,554, highest occupied molecular orbital (HOMO) level: 5.13 eV) (16 mg) and PC61BM (E100H, obtained from Frontier Carbon Corporation) (10 mg) were dissolved in 1 mL of chloroform, to prepare photoelectric conversion layer coating liquid D.

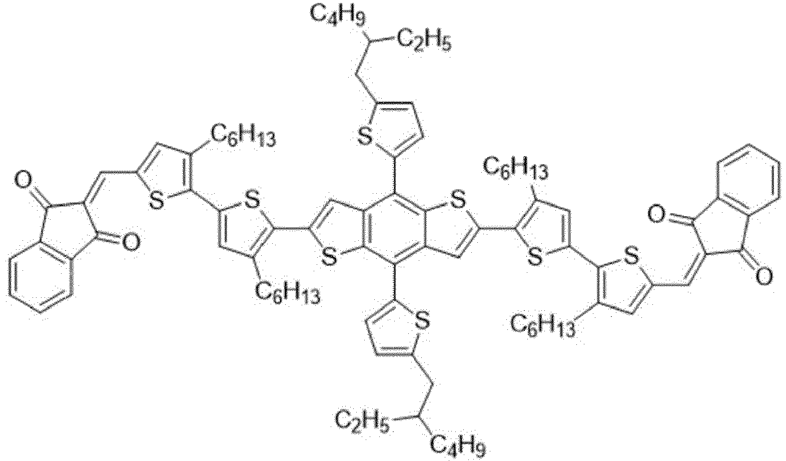

### Exemplary Compound 1

### (Example 15)

### <Production of photoelectric conversion module>

A photoelectric conversion module was produced in the same manner as in the production of the photoelectric conversion module of Example 14, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 16)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid E prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid E-

The following Exemplary Compound 1 (number average molecular weight (Mn)=1,554, highest occupied molecular orbital (HOMO) level: 5.13 eV) (14.5 mg), the following Exemplary Compound 5 (number average molecular weight (Mn)=15,000, highest occupied molecular orbital (HOMO) level: 5.33 eV) (0.9 mg), and PC61BM (E100H, obtained from Frontier Carbon Corporation) (10 mg) were dissolved in 1 mL of chloroform, to prepare photoelectric conversion layer coating liquid E.

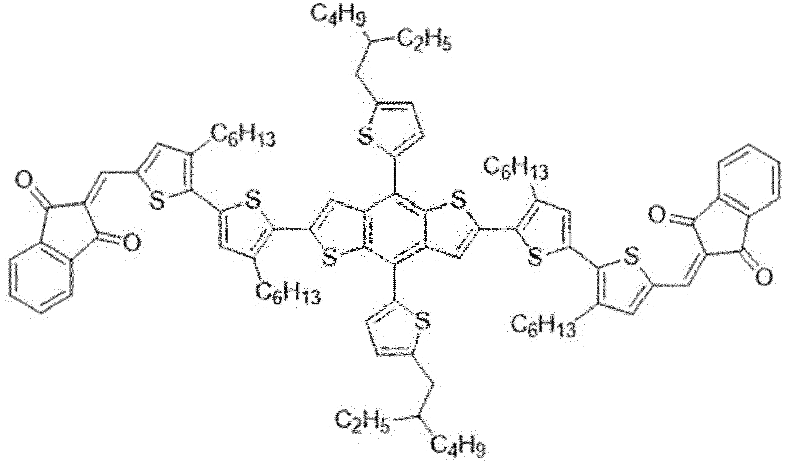

### Exemplary Compound 1

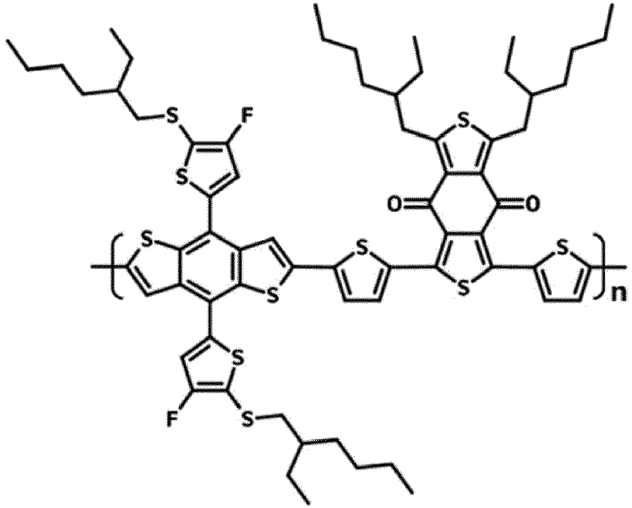

### Exemplary Compound 5

### (Example 17)

### <Production of photoelectric conversion module>

A photoelectric conversion module was produced in the same manner as in the production of the photoelectric conversion module of Example 16, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 18)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid F prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid F-

The following Exemplary Compound 1 (number average molecular weight (Mn)=1,554, highest occupied molecular orbital (HOMO) level: 5.13 eV) (15 mg), the following Exemplary Compound 6 (number average molecular weight (Mn)=15,000, highest occupied molecular orbital (HOMO) level: 5.33 eV) (1 mg), and PC61BM (E100H, obtained from Frontier Carbon Corporation) (10 mg) were dissolved in 1 mL of chloroform, to prepare photoelectric conversion layer coating liquid F.

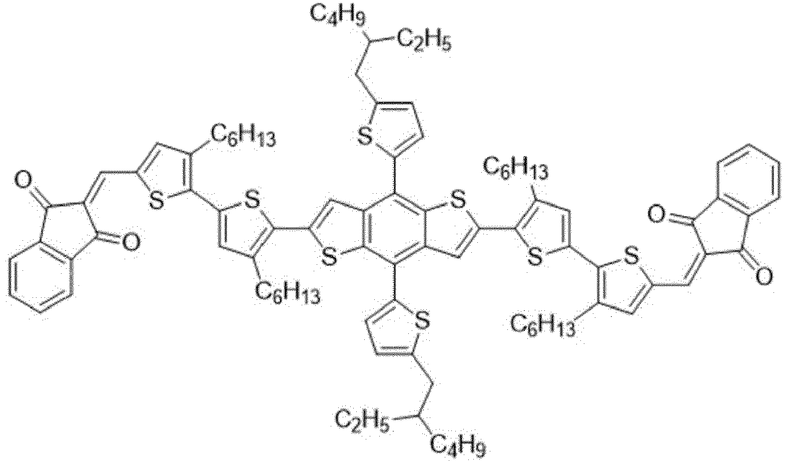

### Exemplary Compound 1

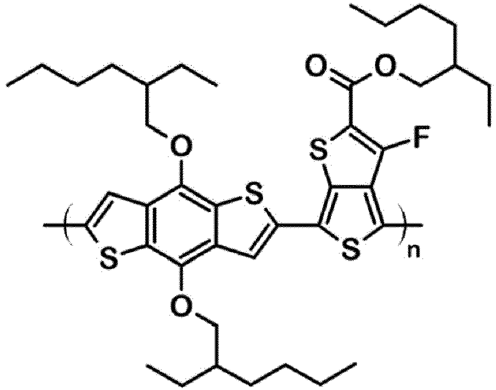

### Exemplary Compound 6

### (Example 19)

### <Production of photoelectric conversion module>

A photoelectric conversion module was produced in the same manner as in the production of the photoelectric conversion module of Example 18, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 20)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid G prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid G-

The following Exemplary Compound 7 (number average molecular weight (Mn)=1,806, highest occupied molecular orbital (HOMO) level: 5.20 eV) (15.5 mg), the following Exemplary Compound 3 (10 mg), and PC61BM (E100H, obtained from Frontier Carbon Corporation) (10 mg) were dissolved in 1 mL of chloroform, to prepare photoelectric conversion layer coating liquid G.

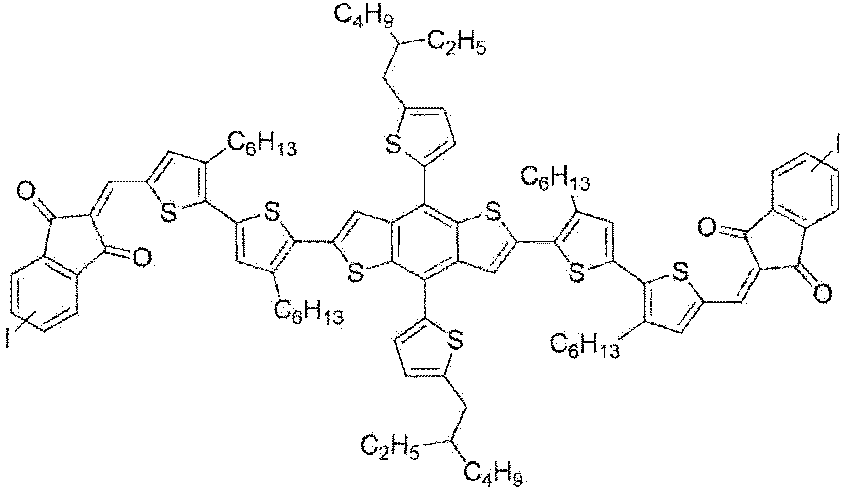

### Exemplary Compound 7

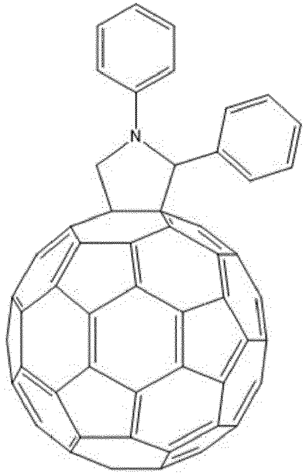

### Exemplary Compound 3

### (Example 21)

### <Production of photoelectric conversion module>

A photoelectric conversion module was produced in the same manner as in the production of the photoelectric conversion module of Example 20, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 22)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid H prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid H-

The following Exemplary Compound 8 (number average molecular weight (Mn)=1,886, highest occupied molecular orbital (HOMO) level: 5.00 eV) (16 mg), and the following Exemplary Compound 3 (10 mg) were dissolved in 1 mL of chloroform, to prepare photoelectric conversion layer coating liquid H.

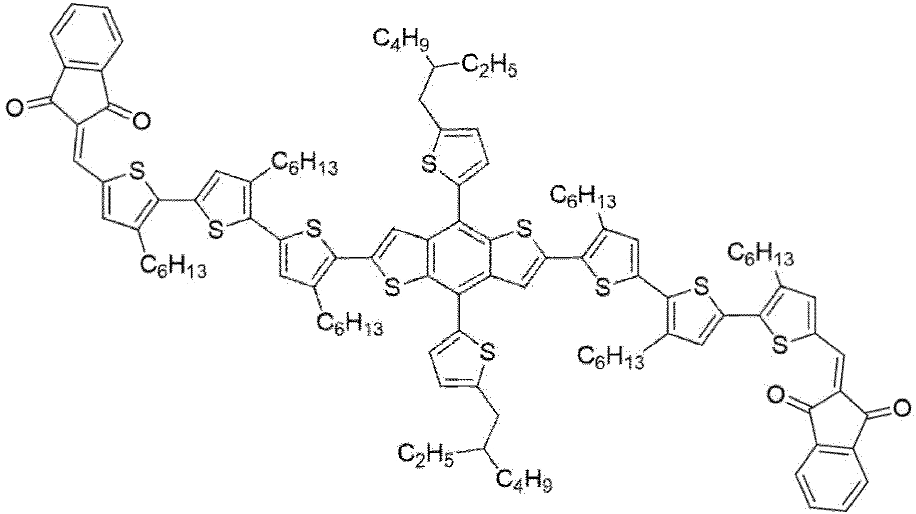

### Exemplary Compound 8

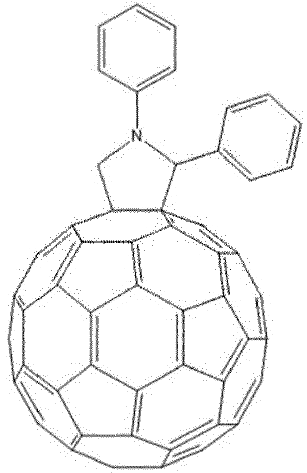

### Exemplary Compound 3

### (Example 23)

### <Production of photoelectric conversion module>

A photoelectric conversion module was produced in the same manner as in the production of the photoelectric conversion module of Example 22, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 24)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid I prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid I-

P3HT (obtained from Ardrich, number average molecular weight (Mn)=54,000, highest occupied molecular orbital (HOMO) level: 5.00 eV) (10 mg) and PC61BM (E100H, obtained from Frontier Carbon Corporation) (10 mg) were dissolved in 1 mL of chloroform, to prepare photoelectric conversion layer coating liquid I.

### (Example 25)

### <Production of photoelectric conversion module>

A photoelectric conversion module was produced in the same manner as in the production of the photoelectric conversion module of Example 24, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 26)

A photoelectric conversion module was produced in the same manner as in the production of the photoelectric conversion module of Example 3, except that the second electron transporting layer (the intermediate layer) was not formed.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 27)

### <Production of photoelectric conversion module>

A photoelectric conversion module was produced in the same manner as in the production of the photoelectric conversion module of Example 26, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Example 28)

### <Production of photoelectric conversion module>

A photoelectric conversion module was produced in the same manner as in the production of the photoelectric conversion module of Example 3, except that the photoelectric conversion layer coating liquid A was changed to photoelectric conversion layer coating liquid J prepared in the following manner.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### -Photoelectric conversion layer coating liquid J-

The following Exemplary Compound 1 (number average molecular weight (Mn)=1,554, highest occupied molecular orbital (HOMO) level: 5.13 eV) (10 mg) and the following Exemplary Compound 9 (ITIC-F, obtained from Merck) (10 mg) were dissolved in 1 mL of chloroform, to prepare photoelectric conversion layer coating liquid J.

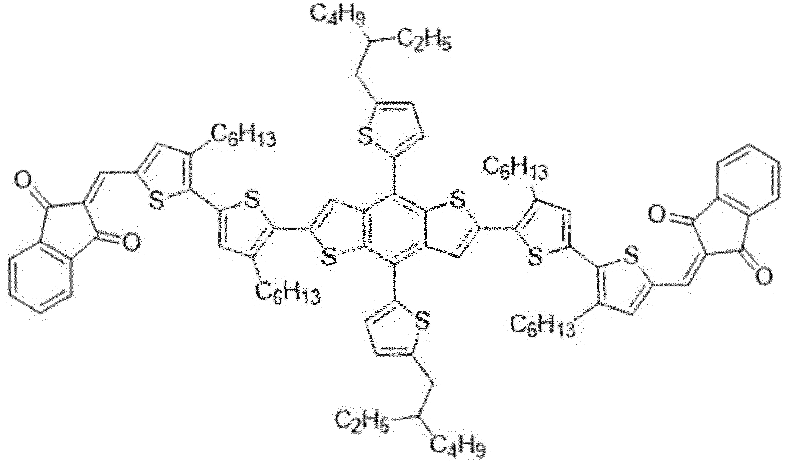

### Exemplary Compound 1

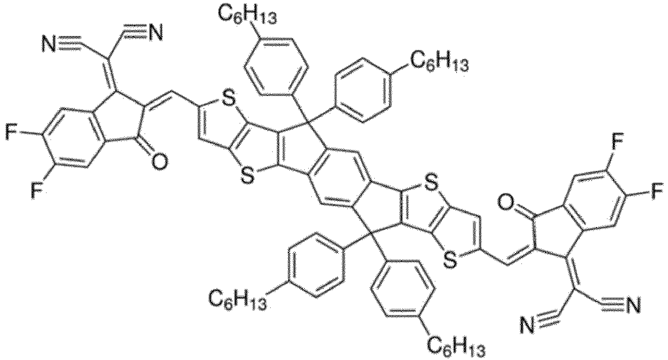

### Exemplary Compound 9

### (Example 29)

### <Production of photoelectric conversion module>

A photoelectric conversion module was produced in the same manner as in the production of the photoelectric conversion module of Example 28, except that the seal region was formed so that the difference between the maximum value Lₘₐₓ and the minimum value Lₘᵢₙ of the length L would be 1,000 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 1.

### (Comparative Example 1)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 2)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 1100 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 3)

### <Production of photoelectric conversion module>

A photoelectric conversion module was produced in the same manner as in the production of the photoelectric conversion module of Example 1, except that the seal region was formed so that the difference between the maximum value Lₘₐₓ and the minimum value Lₘᵢₙ of the length L would be 1300 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 4)

### <Production of photoelectric conversion module>

A photoelectric conversion module was produced in the same manner as in the production of the photoelectric conversion module of Comparative Example 1, except that the sealing member was changed to a sealing member (obtained from tesa tape K.K.) which was formed by combining an adhesive member of an epoxy-based resin with an Al/PET stacked gas barrier member as one single member.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 5)

### <Production of photoelectric conversion module>

A photoelectric conversion module was produced in the same manner as in the production of the photoelectric conversion module of Comparative Example 1, except that the sealing member was changed to a sealing member (obtained from tesa tape K.K.) which was formed by combining an adhesive member of a silicone-based resin with an Al/PET stacked gas barrier member as one single member.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 6)

### <Production of photoelectric conversion module>

A photoelectric conversion module was produced in the same manner as in the production of the photoelectric conversion module of Comparative Example 1, except that the sealing member was changed to a sealing member (obtained from tesa tape K.K.) which was formed by combining an adhesive member of an acryl-based resin with an Al/PET stacked gas barrier member as one single member.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 7)

### <Production of photoelectric conversion module>

A photoelectric conversion module was produced in the same manner as in the production of the photoelectric conversion module of Example 10, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 8)

### <Production of photoelectric conversion module>

A photoelectric conversion module was produced in the same manner as in the production of the photoelectric conversion module of Example 12, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 9)

### <Production of photoelectric conversion module>

A photoelectric conversion module was produced in the same manner as in the production of the photoelectric conversion module of Example 14, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 10)

### <Production of photoelectric conversion module>

A photoelectric conversion module was produced in the same manner as in the production of the photoelectric conversion module of Example 16, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 11)

### <Production of photoelectric conversion module>

A photoelectric conversion module was produced in the same manner as in the production of the photoelectric conversion module of Example 18, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 12)

### <Production of photoelectric conversion module>

A photoelectric conversion module was produced in the same manner as in the production of the photoelectric conversion module of Example 20, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 13)

### <Production of photoelectric conversion module>

A photoelectric conversion module was produced in the same manner as in the production of the photoelectric conversion module of Example 22, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 14)

### <Production of photoelectric conversion module>

A photoelectric conversion module was produced in the same manner as in the production of the photoelectric conversion module of Example 24, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 15)

### <Production of photoelectric conversion module>

A photoelectric conversion module was produced in the same manner as in the production of the photoelectric conversion module of Example 26, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

### (Comparative Example 16)

### <Production of photoelectric conversion module>

A photoelectric conversion module was produced in the same manner as in the production of the photoelectric conversion module of Example 28, except that the seal region was formed so that the difference between the maximum value Lₘₐₓ and the minimum value Lₘᵢₙ of the length L would be 1050 nm.

In the same manner as in Example 1, the difference between the maximum value Lₘₐₓ and the minimum value Lₘᵢₙ of the length L was measured, and the retention rate of photoelectric conversion efficiency was calculated. Results are presented in Table 2.

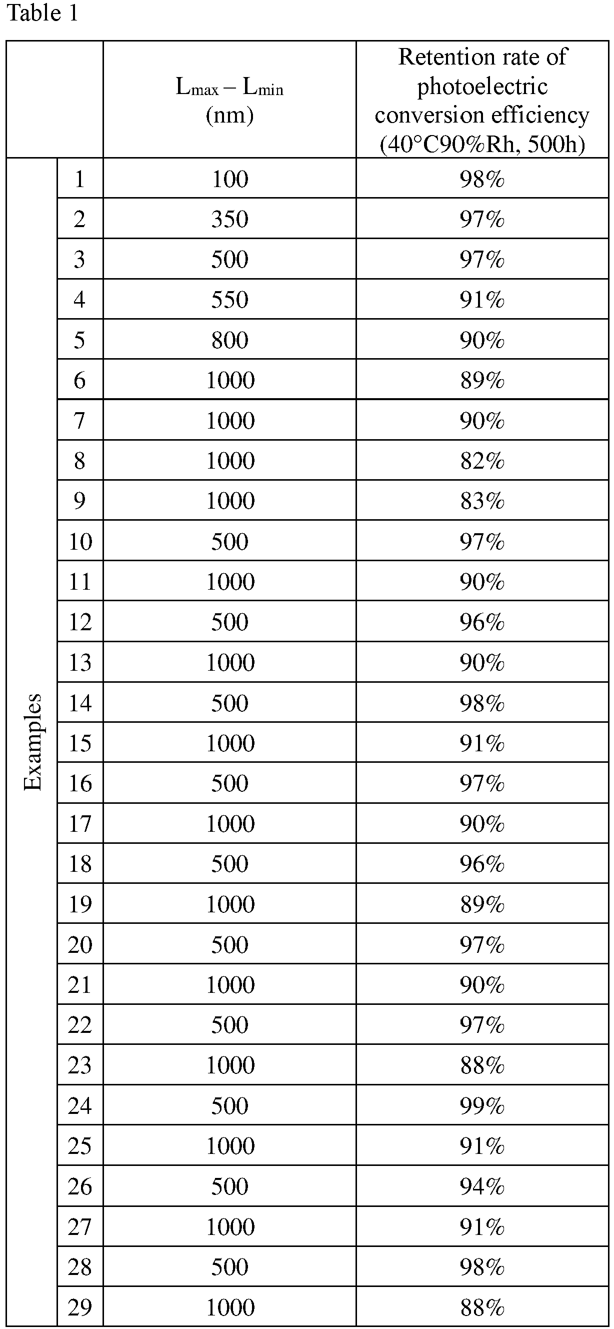

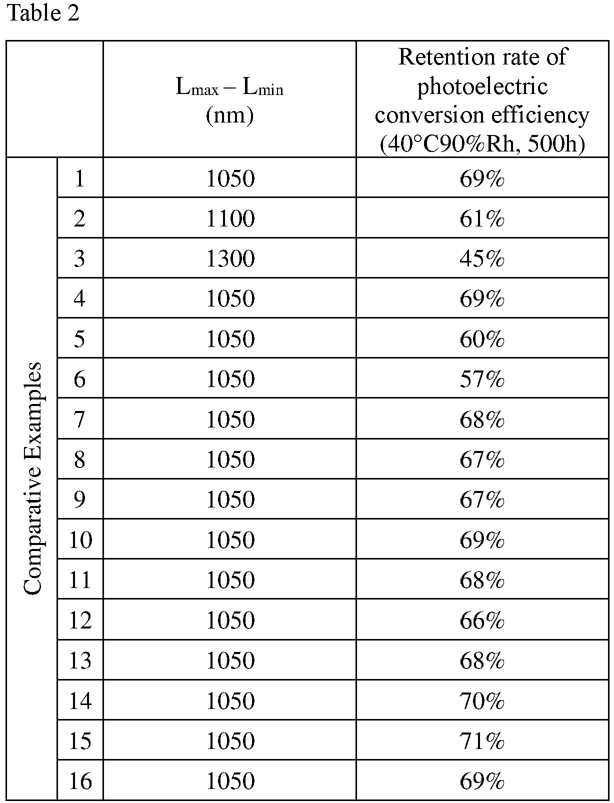

It is found from the results of Table 1 and Table 2 that the photoelectric conversion element of the present disclosure, in which the difference between the maximum value Lₘₐₓ and the minimum value Lₘᵢₙ of the length L is 1,000 nm or less, is prevented from decreasing in photoelectric conversion efficiency even if placed in a high-temperature, high-humidity environment for a long period of time.

## Claims

1. A photoelectric conversion element (1), comprising:
a first electrode (13);
a photoelectric conversion layer (16) over the first electrode (13);
a second electrode (18) over the photoelectric conversion layer (16); and
a sealing member (20) enclosing one electrode selected from the first electrode (13) and the second electrode (18) and the photoelectric conversion layer (16), and adhering to an adhesion region (30) in the other electrode selected from the first electrode (13) and the second electrode (18), **characterized in that**
a cross-section of the photoelectric conversion element (1) in a stacking direction, a difference between a maximum value and a minimum value of a length L is 20 nm or more and 1,000 nm or less, where the length L is a length in the stacking direction from a face (31) of the other electrode where the adhesion region (30) is absent to the sealing member (20) adhering to the adhesion region (30).

2. The photoelectric conversion element (1) according to claim 1, wherein the difference between the maximum value and the minimum value of the length L is 500 nm or less.

3. The photoelectric conversion element (1) according to any one of claims 1 or 2, wherein the sealing member (20) includes an adhesive member (21) adhering to the other electrode, and
the adhesive member (21) contains at least one selected from the group consisting of epoxy-based resins and polyolefin-based resins.

4. The photoelectric conversion element (1) according to any one of claims 1 to 3, wherein the sealing member (20) includes a gas barrier member.

5. The photoelectric conversion element (1) according to any one of claims 1 to 4, further comprising a base (12) facing the face (31) of the other electrode where the adhesion region (30) is absent, wherein the base (12) has gas barrier property.

6. The photoelectric conversion element (1) according to any one of claims 1 to 5, further comprising;
an electron transporting layer (14; 15) between the first electrode (13) and the photoelectric conversion layer (16); and
a hole transporting layer (17) between the photoelectric conversion layer (16) and the second electrode (18).

7. The photoelectric conversion element (1) according to any one of claims 1 to 6, wherein the photoelectric conversion layer (16) includes an organic material having a highest occupied molecular orbital (HOMO) level of 5.1 eV or higher but 5.5 eV or lower and a number average molecular weight (Mn) of 10,000 or lower.

8. The photoelectric conversion element (1) according to any one of claims 1 to 7, wherein the photoelectric conversion layer (16) includes a compound represented by General Formula (1) below: 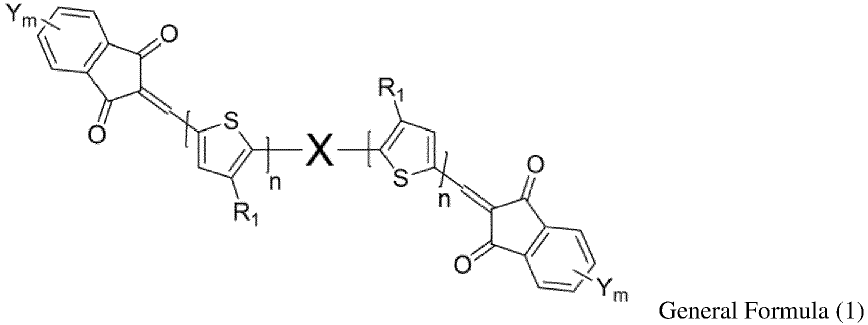 where in the General Formula (1), R₁ represents an alkyl group having carbon atoms of 2 or more but 8 or less, n represents an integer of 1 or greater but 3 or smaller, X represents General Formula (2) below or General Formula (3) below, Y represents a halogen atom, and m represents an integer of 0 or greater but 4 or smaller, 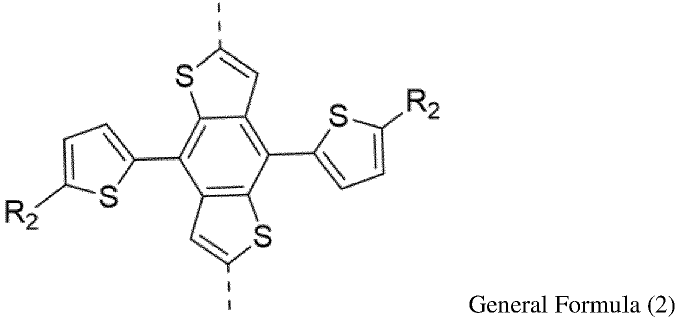 where in the General Formula (2), R₂ represents a straight-chain or branched alkyl group, 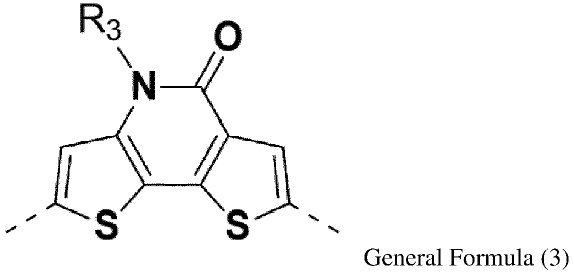 where in the General Formula (3), R₃ represents a straight-chain or branched alkyl group.

9. The photoelectric conversion element (1) according to any one of claims 1 to 8, wherein the photoelectric conversion layer (16) includes an organic material comprising a fullerene derivative.

10. The photoelectric conversion element (1) according to claim 6, wherein the electron transporting layer (14; 15) includes a first electron transporting layer (14) and a second electron transporting layer (15) between the first electron transporting layer (14) and the photoelectric conversion layer (16),
the first electron transporting layer (14) includes particles of a metal oxide, and
the second electron transporting layer (15) includes an amine compound represented by General Formula (4) below: 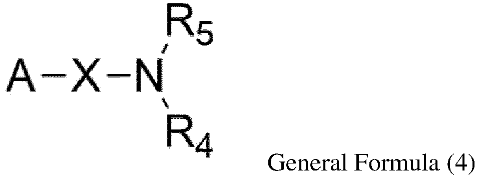
where in the General Formula (4), R₄ and R₅ each independently represent an alkyl group which may have a substituent and contains carbon atoms of 1 or more but 4 or less, or represent a ring structure where R₄ and R₅ are bonded to each other, X represents a divalent aromatic group having carbon atoms of 6 or more but 14 or less or an alkyl group having carbon atoms of 1 or more but 4 or less, and A represents a substituent of Structural Formula (1), (2), or (3) below:
-COOH Structural Formula (1),
-P(-O)(OH)₂ Structural Formula (2),
-Si(OH)₃ Structural Formula (3).

11. An electronic device, comprising:
the photoelectric conversion element (1) according to any one of claims 1 to 10; and
a device that is electrically coupled to the photoelectric conversion element (1).

12. An electronic device, comprising:
the photoelectric conversion element (1) according to any one of claims 1 to 10;
a storage cell that is electrically coupled to the photoelectric conversion element (1); and
a device that is electrically coupled to the photoelectric conversion element (1) and the storage cell.

13. A power supply module, comprising:
the photoelectric conversion element (1) according to any one of claims 1 to 10; and
a power supply IC that is electrically coupled to the photoelectric conversion element (1).

## Patentansprüche

1. Photoelektrisches Umwandlungselement (1), umfassend:
eine erste Elektrode (13);
eine photoelektrische Umwandlungsschicht (16) über der ersten Elektrode (13);
eine zweite Elektrode (18) über der photoelektrischen Umwandlungsschicht (16); und
ein Dichtungselement (20), das eine Elektrode, die aus der ersten Elektrode (13) und der zweiten Elektrode (18) ausgewählt ist, und die photoelektrische Umwandlungsschicht (16) umschließt und an einem Haftbereich (30) in der anderen Elektrode, die aus der ersten Elektrode (13) und der zweiten Elektrode (18) ausgewählt ist, haftet, **dadurch gekennzeichnet, dass**
ein Querschnitt des photoelektrischen Umwandlungselements (1) in einer Stapelrichtung eine Differenz zwischen einem Maximalwert und einem Minimalwert einer Länge L 20 nm oder mehr und 1.000 nm oder weniger beträgt, wobei die Länge L eine Länge in der Stapelrichtung von einer Fläche (31) der anderen Elektrode, wo der Haftbereich (30) nicht vorhanden ist, zu dem Dichtungselement (20) ist, das an dem Haftbereich (30) haftet.

2. Photoelektrisches Umwandlungselement (1) nach Anspruch 1, wobei die Differenz zwischen dem Maximalwert und dem Minimalwert der Länge L 500 nm oder weniger beträgt.

3. Photoelektrisches Umwandlungselement (1) nach einem der Ansprüche 1 oder 2, wobei das Dichtungselement (20) ein Haftelement (21) beinhaltet, das an der anderen Elektrode haftet, und
das Haftelement (21) wenigstens eines beinhaltet, das aus der Gruppe ausgewählt ist, die aus Harzen auf Epoxidbasis und Harzen auf Polyolefinbasis besteht.

4. Photoelektrisches Umwandlungselement (1) nach einem der Ansprüche 1 bis 3, wobei das Dichtungselement (20) ein Gassperrelement beinhaltet.

5. Photoelektrisches Umwandlungselement (1) nach einem der Ansprüche 1 bis 4, das ferner eine Basis (12) umfasst, die der Fläche (31) der anderen Elektrode zugewandt ist, wo der Haftbereich (30) nicht vorhanden ist, wobei die Basis (12) eine Gassperreigenschaft aufweist.

6. Photoelektrisches Umwandlungselement (1) nach einem der Ansprüche 1 bis 5, das ferner umfasst:
eine elektronentransportierende Schicht (14; 15) zwischen der ersten Elektrode (13) und der photoelektrischen Umwandlungsschicht (16); und
eine Lochtransportschicht (17) zwischen der photoelektrischen Umwandlungsschicht (16) und der zweiten Elektrode (18).

7. Photoelektrisches Umwandlungselement (1) nach einem der Ansprüche 1 bis 6, wobei die photoelektrische Umwandlungsschicht (16) ein organisches Material mit einem Niveau des höchsten besetzten Molekularorbitals (HOMO) von 5,1 eV oder mehr, aber 5,5 eV oder weniger und einem zahlenmittleren Molekulargewicht (Mn) von 10.000 oder weniger beinhaltet.

8. Photoelektrisches Umwandlungselement (1) nach einem der Ansprüche 1 bis 7, wobei die photoelektrische Umwandlungsschicht (16) eine Verbindung beinhaltet, die durch die nachstehende allgemeine Formel (1) dargestellt wird: 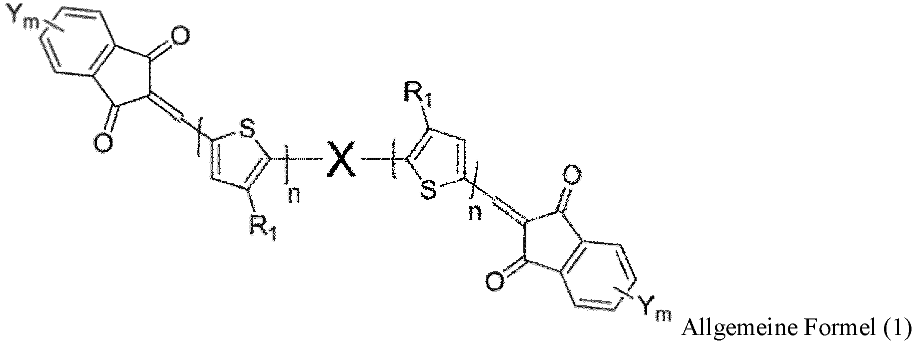 wobei in der allgemeinen Formel (1) R₁ eine Alkylgruppe mit 2 oder mehr, aber 8 oder weniger Kohlenstoffatomen darstellt, n eine ganze Zahl von 1 oder mehr, aber 3 oder weniger darstellt, X die nachstehende allgemeine Formel (2) oder die nachstehende allgemeine Formel (3) darstellt, Y ein Halogenatom darstellt und m eine ganze Zahl von 0 oder mehr, aber 4 oder weniger darstellt, 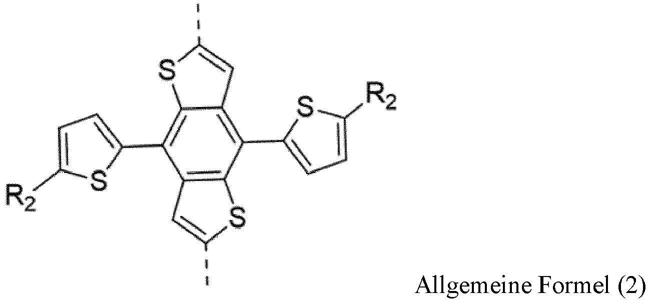 wobei in der allgemeinen Formel (2), R₂ eine geradkettige oder verzweigte Alkylgruppe darstellt, 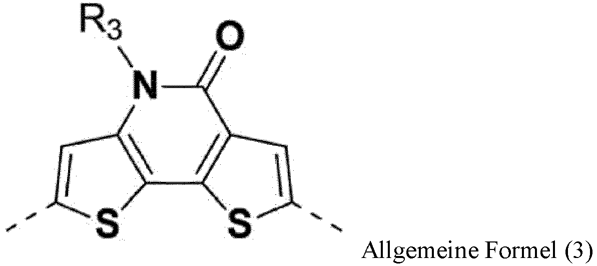 wobei in der allgemeinen Formel (3), R₃ eine geradkettige oder verzweigte Alkylgruppe darstellt,

9. Photoelektrisches Umwandlungselement (1) nach einem der Ansprüche 1 bis 8, wobei die photoelektrische Umwandlungsschicht (16) ein organisches Material beinhaltet, das ein Fullerenderivat umfasst.

10. Photoelektrisches Umwandlungselement (1) nach Anspruch 6, wobei die Elektronentransportschicht (14; 15) eine erste Elektronentransportschicht (14) und eine zweite Elektronentransportschicht (15) zwischen der ersten Elektronentransportschicht (14) und der photoelektrischen Umwandlungsschicht (16) beinhaltet,
die erste Elektronentransportschicht (14) Partikel eines Metalloxids beinhaltet, und
die zweite Elektronentransportschicht (15) eine Aminverbindung beinhaltet, die durch die nachstehende allgemeine Formel (4) dargestellt wird: 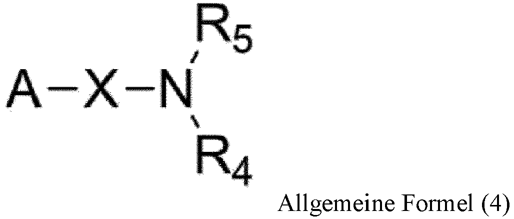
wobei in der allgemeinen Formel (4) R₄ und R₅ jeweils unabhängig voneinander eine Alkylgruppe darstellen, die einen Substituenten aufweisen kann und Kohlenstoffatome von 1 oder mehr, aber 4 oder weniger enthält, oder eine Ringstruktur darstellen, in der R₄ und R₅ aneinander gebunden sind, X eine zweiwertige aromatische Gruppe mit 6 oder mehr, aber 14 oder weniger Kohlenstoffatomen oder eine Alkylgruppe mit 1 oder mehr, aber 4 oder weniger Kohlenstoffatomen darstellt, und A einen Substituenten der nachstehenden Strukturformel (1), (2) oder (3) darstellt:
-COOH Strukturformel (1),
-P(=O)(OH)₂ Strukturformel (2),
-Si(OH)₃ Strukturformel (3).

11. Elektronische Vorrichtung, umfassend:
das photoelektrische Umwandlungselement (1) nach einem der Ansprüche 1 bis 10; und
eine Vorrichtung, die elektrisch mit dem photoelektrischen Umwandlungselement (1) gekoppelt ist.

12. Elektronische Vorrichtung, umfassend:
das photoelektrische Umwandlungselement (1) nach einem der Ansprüche 1 bis 10;
eine Speicherzelle, die elektrisch mit dem photoelektrischen Umwandlungselement (1) gekoppelt ist;
eine Vorrichtung, die elektrisch mit dem photoelektrischen Umwandlungselement (1) gekoppelt ist und die Speicherzelle.

13. Leistungsversorgungsmodul, umfassend:
das photoelektrische Umwandlungselement (1) nach einem der Ansprüche 1 bis 10; und
einen Leistungsversorgungs-IC, der elektrisch mit dem photoelektrischen Umwandlungselement (1) gekoppelt ist.

## Revendications

1. Élément de conversion photoélectrique (1), comprenant :
une première électrode (13) ;
une couche de conversion photoélectrique (16) par-dessus la première électrode (13) ;
une seconde électrode (18) par-dessus la couche de conversion photoélectrique (16) ; et
un organe d'étanchéité (20) entourant une électrode, sélectionnée parmi la première électrode (13) et la seconde électrode (18), et la couche de conversion photoélectrique (16), et adhérant à une région d'adhérence (30) dans l'autre électrode, sélectionnée parmi la première électrode (13) et la seconde électrode (18), **caractérisé en ce que**
une section transversale de l'élément de conversion photoélectrique (1) dans une direction d'empilage, une différence entre une valeur maximum et une valeur minimum d'une longueur L est 20 nm ou plus et 1 000 nm ou moins, où la longueur L est une longueur dans la direction d'empilage depuis une face (31) de l'autre électrode où la région d'adhérence (30) est absente jusqu'à l'organe d'étanchéité (20) adhérant à la région d'adhérence (30).

2. Élément de conversion photoélectrique (1) selon la revendication 1, dans lequel la différence entre la valeur maximum et la valeur minimum de la longueur L est 500 nm ou moins.

3. Élément de conversion photoélectrique (1) selon l'une quelconque des revendications 1 ou 2, dans lequel l'organe d'étanchéité (20) inclut un organe adhésif (21) adhérant à l'autre électrode, et
l'organe adhésif (21) contient au moins un sélectionné parmi le groupe constitué de résines à base d'époxy et de résines à base de polyoléfine.

4. Élément de conversion photoélectrique (1) selon l'une quelconque des revendications 1 à 3, dans lequel l'organe d'étanchéité (20) inclut un organe barrière aux gaz.

5. Élément de conversion photoélectrique (1) selon l'une quelconque des revendications 1 à 4, comprenant en outre une base (12) faisant face à la face (31) de l'autre électrode où la région d'adhérence (30) est absente, dans lequel la base (12) a une propriété barrière aux gaz.

6. Élément de conversion photoélectrique (1) selon l'une quelconque des revendications 1 à 5, comprenant en outre ;
une couche de transport d'électrons (14 ; 15) entre la première électrode (13) et la couche de conversion photoélectrique (16) ; et
une couche de transport de trous (17) entre la couche de conversion photoélectrique (16) et la seconde électrode (18).

7. Élément de conversion photoélectrique (1) selon l'une quelconque des revendications 1 à 6, dans lequel la couche de conversion photoélectrique (16) inclut un matériau inorganique ayant un niveau d'orbitale moléculaire occupée la plus haute (HOMO) de 5,1 eV ou plus mais de 5,5 eV ou moins et un poids moléculaire moyen en nombre (Mn) de 10 000 ou moins.

8. Élément de conversion photoélectrique (1) selon l'une quelconque des revendications 1 à 7, dans lequel la couche de conversion photoélectrique (16) inclut un composé représenté par la formule générale (1) ci-dessous : 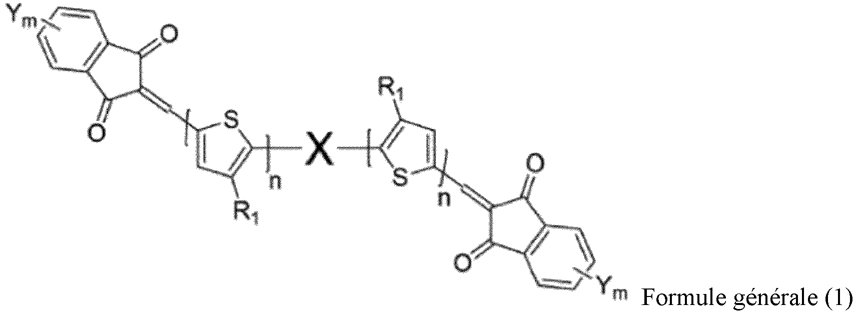 où, dans la formule générale (1), R₁ représente un groupe alkyle ayant des atomes de carbone de 2 ou plus mais de 8 ou moins, n représente un nombre entier relatif de 1 ou plus mais de 3 ou moins, X représente la formule générale (2) ci-dessous ou la formule générale (3) ci-dessous, Y représente un atome d'halogène, et m représente un nombre entier relatif de 0 ou plus mais de 4 ou moins, 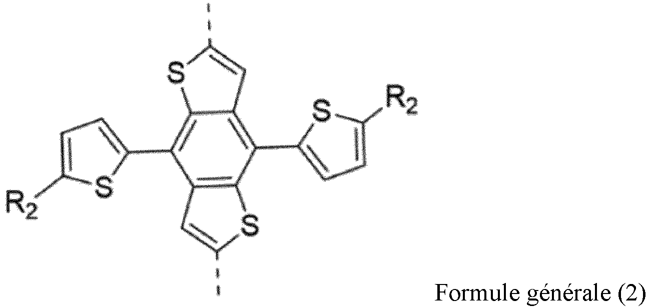 où, dans la formule générale (2), R₂ représente un groupe alkyle ramifié ou à chaîne droite, 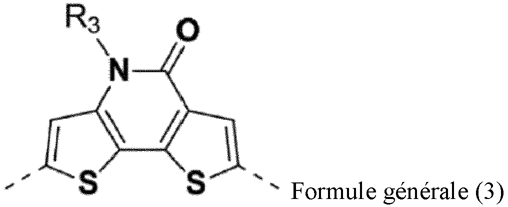 où, dans la formule générale (3), R₃ représente un groupe alkyle ramifié ou à chaîne droite.

9. Élément de conversion photoélectrique (1) selon l'une quelconque des revendications 1 à 8, dans lequel la couche de conversion photoélectrique (16) inclut un matériau inorganique comprenant un dérivé fullerène.

10. Élément de conversion photoélectrique (1) selon la revendication 6, dans lequel la couche de transport d'électrons (14 ; 15) inclut une première couche de transport d'électrons (14) et une seconde couche de transport d'électrons (15) entre la première couche de transport d'électrons (14) et la couche de conversion photoélectrique (16),
la première couche de transport d'électrons (14) inclut des particules d'un oxyde de métal, et
le seconde couche de transport d'électrons (15) inclut un composé amine représenté par la formule générale (4) ci-dessous : 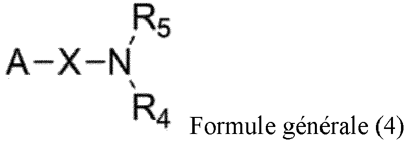
où, dans la formule générale (4), R₄ et R₅ représentent chacun indépendamment un groupe alkyle qui peut avoir un substituant et contient des atomes de carbone de 1 ou plus mais de 4 ou moins, ou représentent une structure d'anneau où R₄ et R₅ sont liés l'un à l'autre, X représente un groupe aromatique divalent ayant des atomes de carbone de 6 ou plus mais de 14 ou moins ou un groupe alkyle ayant des atomes de carbone de 1 ou plus mais de 4 ou moins, et A représente un substituant de la formule structurale (1), (2), ou (3) ci-dessous :
-COOH Formule structurale (1),
-P(=O)(OH)₂ Formule structurale (2),
-Si(OH)₃ Formule structurale (3).

11. Dispositif électronique, comprenant :
l'élément de conversion photoélectrique (1) selon l'une quelconque des revendications 1 à 10 ; et
un dispositif qui est électriquement couplé à l'élément de conversion photoélectrique (1).

12. Dispositif électronique, comprenant :
l'élément de conversion photoélectrique (1) selon l'une quelconque des revendications 1 à 10 ;
une cellule de stockage qui est électriquement couplée à l'élément de conversion photoélectrique (1) ; et
un dispositif qui est électriquement couplé à l'élément de conversion photoélectrique (1) et la cellule de stockage.

13. Module d'alimentation électrique, comprenant :
l'élément de conversion photoélectrique (1) selon l'une quelconque des revendications 1 à 10 ; et
un IC d'alimentation électrique qui est électriquement couplé à l'élément de conversion photoélectrique (1).
